# EUROPÄISCHE PATENTSCHRIFT

(11) **EP 3 036 772 B1**
(45) Veröffentlichungstag und Bekanntmachung des Hinweises auf die Patenterteilung: **19.06.2019**
(21) Anmeldenummer: 14752843.4
(22) Anmeldetag: 14.08.2014
(51) Int. Cl.: H01L 31/0216, H01L 31/0232, H01L 31/056

(54) **PHOTOZELLE, INSBESONDERE SOLARZELLE SOWIE VERFAHREN ZUM HERSTELLEN EINER PHOTOZELLE**
PHOTOCELL, IN PARTICULAR SOLAR CELL AND METHOD FOR PRODUCING A PHOTOCELL
CELLULE PHOTOÉLECTRIQUE, EN PARTICULIER CELLULE SOLAIRE, AINSI QUE PROCÉDÉ DE FABRICATION D'UNE CELLULE PHOTOÉLECTRIQUE

(30) Priorität: 23.08.2013 DE 102013109143
(43) Veröffentlichungstag der Anmeldung: 29.06.2016
(73) Patentinhaber: f.u.n.k.e. NANOSOLAR GmbH, 79331 Teningen-Nimburg (DE)
(72) Erfinder: LUPACA-SCHOMBER, Jaime, 76137 Karlsruhe (DE); LUPACA-SCHOMBER, Ricardo, 76187 Karlsruhe (DE); MERLEIN, Joerg Andreas, 21031 Hamburg (DE)
(74) Vertreter: Witte, Weller & Partner Patentanwälte mbB
(86) Internationale Anmeldenummer: PCT/EP2014/067450
(87) Internationale Veröffentlichungsnummer: WO 2015/024866

(56) Entgegenhaltungen:
- EP-A1- 2 544 218
- WO-A1-2012/123620
- US-A1- 2008 042 563
- US-A1- 2009 253 227
- US-A1- 2010 259 826
- US-A1- 2013 092 211
- US-B1- 8 216 872
- CATCHPOLE K ET AL: "Design principles for particle plasmon enhanced solar cells", APPLIED PHYSICS LETTERS, AMERICAN INSTITUTE OF PHYSICS, US, Bd. 93, Nr. 19, 14. November 2008 (2008-11-14), Seiten 191113-191113, XP012112261, ISSN: 0003-6951, DOI: 10.1063/1.3021072

## Beschreibung

Die Erfindung betrifft eine Photozelle, insbesondere eine Solarzelle, mit einer Absorberschicht, vor eine der Antireflexionsschicht angeordnet ist.

Bei der Herstellung von Solarzellen wird weltweit seit Jahren daran gearbeitet, den Wirkungsgrad zu erhöhen. Solarzellen werden bislang überwiegend aus Silizium hergestellt, wobei Standard-Dickschicht-Solarzellen meist eine Dicke in der Größenordnung von bis zu 200 Mikrometer haben und aus monokristallinem Silizium hergestellt werden. Während bei monokristallinen Solarzellen das Silizium von hoher Qualität und defektfrei sein muss, sind in jüngerer Zeit auch Dünnschichtsolarzellen mit Dicken von wenigen Mikrometern oder sogar darunter in der Entwicklung.

Bei der Wirkungsgraderhöhung von Solarzellen geht es im Wesentlichen um zwei physikalisch unabhängige Prozesse:
- Zum Einen geht es darum, das Licht optimal in die Zelle einzukoppeln und solange wie möglich in der Zelle zu halten, d.h. so viele Photonen wie möglich sollen in der Zelle absorbiert werden. Es geht also um ein optimiertes Photonen-Management.
- Zum anderen geht es darum, die generierten elektrischen Ladungen (nach der Lichtabsorption) so gut wie möglich aus der Zelle zum Verbraucher zu bringen. Es geht also darum, Verlustprozesse zu minimieren, d.h. es geht um ein verbessertes Elektronen-Management.

Jede Verbesserung im Photonen-Management erhöht die Anzahl der absorbierten Photonen in der Solarzelle unmittelbar. Je besser also das Photonen-Management ist, desto höher ist die Effizienz der Solarzelle unabhängig vom aktuellen Elektronen-Management der Zelle.

Um die Absorption bei Solarzellen zu erhöhen, wird standardmäßig eine Antireflexionsschicht (AR-Schicht) verwendet, die geometrisch strukturiert ist, und zwar in Form einer Pyramidenstruktur oder einer invertierten Pyramidenstruktur. Hierdurch wird eine deutliche Verbesserung im Photonen-Management von Solarzellen erzielt und dadurch der Wirkungsgrad um etwa 10 % (relativ) verbessert, d.h. eine Solarzelle mit z.B. 20 % Wirkungsgrad kann durch die Verwendung einer AR-Schicht mit Pyramidenstruktur im Wirkungsgrad auf 22 % gesteigert werden.

Die AR-Schicht besteht in der Regel aus Siliziumnitrid und ist als eine regelmäßige Pyramidenstruktur ausgebildet, wobei die Basis der quadratischen Pyramiden meist 2 bis 10 Mikrometer lang ist. Der Spitzenwinkel der Pyramiden mit quadratischer Grundfläche liegt bei etwa 70°.

Nachteilig bei derartigen AR-Schichten ist insbesondere, dass die Struktur nur in einem sehr schmalen Wellenlängenbereich des Sonnenspektrums optimal arbeitet.

Aus diesem Grunde wird versucht, ein verbessertes Photonen-Management durch plasmonische Strukturen zu erreichen.

Gemäß V.E. Ferry, J.N. Munday, H.A. Atwater, "Design Considerations for Plasmonic Photovoltaics", Advanced Materials 2010 Adv. Mater. 2010, 22, 4794-4808 soll durch die Einbindung von plasmonischen Nanostrukturen das Absorptionsproblem insbesondere bei Dünnschichtzellen umgangen werden. Oberflächenplasmonen sind gebundene elektromagnetische Oszillationen von Elektronen an der Grenzfläche zwischen einem Metall und einem dielektrischen Material. Sie können Licht leiten und in kleinen Volumina sammeln.

Ein erster Ansatz zur Verbesserung von Solarzellen durch plasmonische Strukturen bestand hiernach darin, bei einer herkömmlichen Siliziumsolarzelle zusätzlich auf der Oberfläche Nanopartikel aufzubringen, was durch Abscheiden einer dünnen Metallschicht und Glühen unter Stickstoff erfolgt, so dass sich die Struktur in diskrete Inseln umwandelte. Die sich ergebenden Strukturen waren allerdings irregulär. Gemäß einem zweiten Ansatz wurden kolloidale Silber- und Gold-Nanopartikel als Quelle von Streuelementen verwendet. Dies führte zu einer gleichförmigen Größe und einer gleichförmigen Dichteverteilung von Partikeln auf der Oberfläche. Diese Abscheidungsart wurde bei kristallinem Silizium, amorphem Silizium und InP/InGaAsP-Zellen verwendet. Teilweise wurde eine Wirkungsgradverbesserung von 8 % bei Silber-Nanopartikeln beobachtet. Weiterhin wurden die Auswirkungen der Größe und Dichteverteilung von Nanopartikeln auf GaAs-Solarzellen unter Verwendung von AAO-Masken ("anodic aluminum oxide") als Verdampfungsmasken als ein Mittel zur Kontrolle der Höhe und Dichte der abgeschiedenen Nanopartikeln untersucht. Die höchsten Wirkungsgraderhöhungen wurden bei dichten, hohen Anordnungen von Partikeln beobachtet, was auf die Nahfeld-Kopplung zwischen den Partikeln zurückgeführt wurde.

Es wurde auch die Auswirkung einer nanostrukturierten AR-Schicht aus Silber auf der Oberfläche des Siliziums untersucht. Bei den nanostrukturierten Streuobjekten handelte es sich um Rippen von 100 Nanometer Breite und 50 Nanometer Höhe, ausgehend von der Rückseite der Zelle in den Halbleiter. Es wurden sowohl Abstände von 6 Mikrometer als auch von 300 Nanometer untersucht und hierbei gewisse Absorptionsverbesserungen festgestellt.

Gemäß H.A. Atwater und A. Polman, "Plasmonics for improved photovoltaic devices", Nature Materials, Vol. 9, März 2010, 205-213, werden plasmonische Solarzellenstrukturen in Betracht gezogen, bei denen eine resonante Plasmonen-Anregung bei Dünnfilm-Solarzellen unter Ausnutzung der starken Nahfeldverstärkung um die metallischen Nanopartikel gemacht wurde, um die Absorption in einem umgebenden Halbleitermaterial zu verbessern. Die Nanopartikel wirken dann als Antenne für das einfallende Sonnenlicht, das in einer lokalisierten Oberflächen-Plasmonenmode gespeichert wird. Dies soll insbesondere für kleine Partikeldurchmesser von 5 bis 20 Nanometer gut arbeiten.

Zur großflächigen Herstellung von plasmonischen Solarzellenstrukturen wurde die Formung von metallischen Nanopartikeln durch thermisches Verdampfen einer dünnen Metallschicht in Betracht gezogen, die anschließend beheizt wird, um Agglomerate auf der Oberfläche zu bilden. Dies führte zu unregelmäßig angeordneten Nanopartikeln mit einem Durchmesser von 100 bis 150 Nanometer. Durch Lithographie mit einem Stempel, bei der eine Sol-Gel-Maske durch Weichlithographie unter Verwendung eines Gummistempels, gefolgt von Silberaufdampfung und anschließendem Ablösen, soll eine Auflösung von < 0,1 Nanometer erzielt werden. Hierdurch wurden hexagonale Arrays aus Silber-Nanopartikeln mit einem Partikeldurchmesser von 300 Nanometer und etwa halbkugelförmiger Gestalt mit einem Abstand von etwa 500 Nanometern erzeugt.

Die herkömmlichen Strukturen mit optischen Antireflexionsschichten in Pyramidenform und auch die neueren Ansätze mit plasmonischen Strukturen liefern zwar vereinzelt Verbesserungen des Photonen-Managements, sind jedoch noch nicht ausreichend weit entwickelt, um deutliche Verbesserungen zu gewährleisten.

Aus Catchpole, K. et al.: "Design Principles for Particle Plasmon Enhanced Solar Cells", Applied Physics Letters 93, 191113 (2008) ist eine Solarzelle bekannt, mit einer Absorberschicht aus Silizium, vor der eine Antireflexionsschicht mit einer nanostrukturierten Schicht aus Ag-Zylindern mit einem Durchmesser und einer Höhe von 100 Nanometern auf einer Unterschicht aus Si3N4 mit einer Dicke von 10 bzw. 30 Nanometern auf Silizium bekannt ist. Die Zylinder sind mit einer 30 Nanometern dicken Beschichtung aus Si3N4 beschichtet.

Aus der US 2013/0092211 A1 ist ferner bekannt, bei Solarzellen zur Verringerung der Reflexion ein Metall-Gitter mit Streifen oder Pads zur Erzeugung von Oberflächen-Plasmonen-Resonanzen vorzusehen, bei dem der Abstand der Streifen oder Pads weniger als 250 Nanometer, vorzugsweise 150 bis 250 Nanometer beträgt, die Breite der Streifen oder Pads weniger als 150 Nanometer, vorzugsweise 80 bis 120 Nanometer beträgt, und wobei die Höhe 30 Nanometer beträgt.

Ferner sei auf die WO 2012/123 620 A1 hingewiesen, aus der eine dünne Photovoltaikzelle mit einer Nanoantennenstruktur bekannt ist. Die Photovoltaikzelle weist ein Substrat, eine erste dielektrische Schicht auf dem Substrat, eine aktive Schicht auf der ersten dielektrischen Schicht und eine plasmonische Lichtkonzentratoranordnung auf der aktiven Schicht auf, um einfallendes Licht eines ersten Wellenlängenbereiches in die aktive Schicht einzukoppeln. Die Photovoltaikzelle weist ferner eine zweite dielektrische Schicht auf, die gegenüber dem ersten Wellenlängenbereich und bei einem zweiten Wellenlängenbereich auf der plasmonischen Lichtkonzentratoranordnung durchlässig ist. Dabei sind die erste dielektrische Schicht, die aktive Schicht, die plasmonische Lichtkonzentratoranordnung und die zweite dielektrische Schicht dazu ausgebildet, einen Resonanzhohlraum zum Einkoppeln von einfallendem Licht bei dem zweiten Wellenlängenbereich in eine in dem Resonanzhohlraum stehende Welle zu bilden.

Vor diesem Hintergrund liegt der Erfindung die Aufgabe zugrunde, eine verbesserte Photozelle, insbesondere Solarzelle, anzugeben, mit der eine merkliche Verbesserung des Photonen-Managements erzielt werden kann.

Diese Aufgabe wird erfindungsgemäß durch eine Photozelle, insbesondere eine Solarzelle, mit den Merkmalen des Anspruchs 1 gelöst.

Die Aufgabe der Erfindung wird auf diese Weise vollkommen gelöst.

Erfindungsgemäß wird durch die Verwendung einer nanostrukturierten Schicht mit periodisch angeordneten Antennenelementen aus einem elektrisch leitfähigen Material, die in einem Abstand von 1 bis 50 Nanometer von der Absorberschicht angeordnet ist, wobei die Antennenelemente mit einem Abstand von mehr als 250 bis 750 Nanometern zueinander angeordnet sind und eine Höhe von mehr als 30 bis 120 Nanometern aufweisen, eine deutliche Verbesserung des Photonen-Managements erreicht, d.h. insgesamt eine deutliche Verbesserung der Absorption in der Solarzelle. Die Antennenelemente können das gesamte Sonnenlichtspektrum (von 280 Nanometer bis 1100 Nanometer Wellenlänge) breitbandig gut in die Solarzelle einkoppeln und das Licht länger in der Solarzelle halten, als die bisher verwendeten Mikrostrukturen, da die Nano-Antennenelemente das absorbierte Licht in der Solarzelle wieder aufnehmen (empfangen) und in die Solarzelle zurückstrahlen. Auf diese Weise kann mit der neuartigen nanostrukturierten Schicht das Licht etwa um einen Faktor von 2 besser absorbiert werden als mit herkömmlichen AR-Schichten in Pyramidenform (der Wirkungsgrad kann um etwa 20% (relativ) verbessert werden). Bei der erfindungsgemäßen nanostrukturierten Schicht mit periodisch angeordneten Antennenelementen wirken diese als Oberflächenplasmonen mit definierten Nahfeldeigenschaften. Die nanostrukturierte Schicht bildet zusammen mit einem Rückkontakt der Photozelle einen optischen Resonator.

Die im Stand der Technik bisher bekannten Plasmonen-Strukturen mit nanostrukturierten Schichten weisen entweder keine periodisch angeordneten Antennenelemente auf oder sind noch dermaßen unbestimmt, dass sich keine optimierten Eigenschaften über einen weiten Bereich erzielen lassen.

Ein besonderer Vorteil der erfindungsgemäßen Photozelle besteht darin, dass die nanostrukturierte Schicht mit periodisch angeordneten Antennenelementen bei allen Arten von Photozellen unabhängig vom Aufbau der Photozelle selbst verwendbar ist.

Bei den erfindungsgemäßen Photozellen wird das Licht über einen größeren Winkelbereich eingesammelt und in das Substrat eingestrahlt, da die Plasmonen als Antennen wirken. Auch wird eine Unschärfe bei Bestrahlung mit Infrarotlicht durch Modenbildung reduziert. Die Moden bilden sich nämlich auch in Bereichen der Sensorschicht aus, wodurch ein verbessertes Einsammeln der erzeugten Elektronen möglich ist.

Gemäß einer weiteren Ausgestaltung der Erfindung ist die nanostrukturierte Schicht mit einem Abstand von 2 bis 20 Nanometer von der Absorberschicht angeordnet, vorzugsweise mit einem Abstand von 5 bis 15 Nanometer, besonders bevorzugt mit einem Abstand von 7 bis 12 Nanometer.

Es hat sich gezeigt, dass mit einem derartigen Abstand besonders gute Eigenschaften, insbesondere eine besonders gute Absorptionsverbesserung über einen weiten Wellenlängenbereich erzielt werden können.

Einzelne Antennenelemente sind vorzugsweise entweder orthogonal oder hexagonal zueinander periodisch angeordnet.

Die maximale Ausdehnung der Antennenelemente in Querrichtung beträgt vorzugsweise 20 bis 400 Nanometer, weiter bevorzugt 40 bis 250 Nanometer, besonders bevorzugt 100 bis 250 Nanometer.

Die minimale Ausdehnung der Antennenelemente in Querrichtung beträgt vorzugsweise 25 Nanometer, weiter bevorzugt 30 Nanometer, besonders bevorzugt mindestens 50 Nanometer.

Mit einer derartigen Dimensionierung können besonders vorteilhafte Eigenschaften in weiten Bereichen insbesondere an bestimmte Zellstrukturen angepasst werden, um insgesamt eine verbesserte Absorption über ein bestimmtes Frequenzspektrum zu erreichen, oder um ggf. besondere Frequenzbereiche besonders zu verstärken, so dass auch ein Einsatz als Photozellen im Bereich der optischen Sensoren möglich ist.

Die nanostrukturierte Schicht mit den Antennenelementen ist vorzugsweise zumindest teilweise in der Antireflexionsschicht aufgenommen, die vorzugsweise aus SiOxNy (beispielsweise SiO3N4), Titanoxid oder ITO ("Indium-Tin-Oxide") besteht. Soweit die nanostrukturierte Schicht infolge ihrer Höhe aus der Antireflexionsschicht teilweise hervorsteht, liegt diese vorzugsweise in einer darüber aufgebrachten Schutzschicht, die etwa aus Siliziumoxid bestehen kann.

Die nanostrukturierte Schicht kann aus identischen Antennenelementen bestehen oder auch aus Antennenelementen unterschiedlicher Form und/oder Größe, die in einem regelmäßigen Muster miteinander kombiniert sind.

Gemäß einer weiteren Ausgestaltung der Erfindung besteht die nanostrukturierte Schicht aus kreisförmigen, vieleckförmigen, dreieckförmigen oder quadratischen Antennenelementen, aus kreuzförmigen Antennenelementen, in Form von miteinander gekreuzten Balken in symmetrischer Ausgestaltung, in Form eines Quadrats mit kleineren an jeder Außenseite angesetzten Quadraten in symmetrischer Ausgestaltung, in Form eines Quadrates mit quadratischen Aussparungen in jedem Eckbereich in symmetrischer Ausgestaltung, oder in Form eines Kreises mit vier tangential aufgesetzten Rechtecken in symmetrischer Ausgestaltung, wobei die Rechtecke entweder in Richtung einer Elementarzelle angeordnet sind oder um 45° versetzt dazu, oder besteht aus sternförmigen Elementen mit sechs Spitzen, die hexagonal auf einer Elementarzelle angeordnet sind, wobei jeweils die Spitzen der sternförmigen Antennenelemente zueinander zeigen oder die Seiten zwischen den Spitzen zueinander zeigen.

Mit derartigen Antennenelementen lässt sich in Abhängigkeit vom jeweiligen Anwendungsfall, d.h. insbesondere eine Absorptionsverbesserung bei einer bestimmten Solarzelle, oder eine gezielte Verstärkung eines bestimmten Frequenzbereiches, oder Filterung eines bestimmten Frequenzbereiches bei einer Anwendung als Sensor erreichen.

Vorzugsweise sind die Antennenelemente als Zylinder oder als gerade Prismen ausgebildet, die sich senkrecht zu einer Haupterstreckungsrichtung der Photozelle erstrecken.

Weiter bevorzugt bestehen die Antennenelemente aus einem Metall, das aus der Gruppe ausgewählt ist, die Silber, Kupfer, Aluminium, Gold und deren Legierungen enthält.

In den meisten Fällen ist Silber besonders bevorzugt, jedoch können für einzelne Anwendungen auch andere Metalle vorteilhaft sein.

Gemäß einer weiteren Ausgestaltung der Erfindung bestehen die Antennenelemente aus einem Metall, das aus der Gruppe ausgewählt ist, die Silber, Kupfer, Aluminium, Gold und deren Legierungen enthält, und wobei zumindest eine dem Absorber zugewandte oder dem Absorber abgewandte Seite der Antennenelemente mit einem anderen Metall beschichtet ist, das aus der Gruppe ausgewählt ist, die Silber, Kupfer, Aluminium, Gold und deren Legierungen enthält.

Durch eine derartige Beschichtung der Antennenelemente auf der einen oder der anderen Seite oder auf beiden Seiten, können gezielte Eigenschaftsverbesserungen erreicht werden.

Gemäß einer weiteren Ausgestaltung der Erfindung besteht die nanostrukturierte Schicht aus geraden Zylindern. Dieses ist insbesondere dann vorteilhaft, wenn die Photozelle als Solarzelle, insbesondere als Siliziumsolarzelle ausgestaltet ist.

Es hat sich gezeigt, dass durch die Ausgestaltung der nanostrukturierten Schicht mit geraden Zylindern sich eine besonders gute Absorptionserhöhung über den gesamten Spektralbereich des Sonnenlichtes erzielen lässt.

Gemäß einer Weiterbildung dieser Ausführung besteht die nanostrukturierte Schicht aus Zylindern mit einem Durchmesser von 150 bis 250 Nanometern, vorzugsweise von 180 bis 200 Nanometern, und mit einer Höhe von 50 bis 90 Nanometern, die vorzugsweise in einem orthogonalen Muster mit einem Abstand von 400 bis 600 Nanometern, vorzugsweise 450 bis 510 Nanometern angeordnet sind und einen Abstand zur Absorberschicht von 5 bis 13 Nanometern, vorzugsweise von 8 bis 10 Nanometern, aufweisen.

Hiermit ergeben sich optimale Eigenschaften für Standard-Solarzellen, d.h. monokristalline Solarzellen, mit einer Dicke von etwa 180 bis 200 Mikrometer.

In weiter bevorzugter Ausgestaltung der Erfindung ist die Solarzelle als Standard-Dickschicht-Solarzelle mit einer Dicke von bis zu 200 Mikrometer ausgebildet, wobei die Zylinder der nanostrukturierten Schicht einen Durchmesser von 185 bis 195 Nanometern, vorzugsweise etwa 190 Nanometer, haben, eine Höhe von 68 bis 72 Nanometern, vorzugsweise etwa 70 Nanometer, einen Abstand zur Absorberschicht von 8,5 bis 9,5 Nanometern, vorzugsweise etwa 9 Nanometer, aufweisen und mit einem Abstand von 460 bis 470 Nanometern, vorzugsweise etwa 465 Nanometer, in einem orthogonalen Muster zueinander angeordnet sind.

Hiermit ergeben sich optimale Bedingungen für eine Standard-Dickschicht-Solarzelle.

Gemäß einer weiteren Ausgestaltung der Erfindung ist die Solarzelle als HIT-Dickschicht-Solarzelle mit einer Dicke von bis zu 200 Mikrometer ausgebildet, wobei die Zylinder der nanostrukturierten Schicht einen Durchmesser von etwa 185 bis 195 Nanometern, vorzugsweise etwa 190 Nanometer, haben, eine Höhe von 68 bis 72 Nanometern, vorzugsweise etwa 70 Nanometer, einen Abstand zur Absorberschicht von 8,5 bis 9,5 Nanometern, vorzugsweise etwa 9 Nanometer aufweisen und mit einem Abstand von 485 bis 495 Nanometern, vorzugsweise etwa 490 Nanometer, in einem orthogonalen Muster zueinander angeordnet sind. Hiermit ergeben sich optimale Eigenschaften für eine HIT-Dickschicht-Solarzelle ("hetero junction with intrinsic thin layer"-HIT).

Bei einer Ultradünnschichtsolarzelle besteht die nanostrukturierte Schicht vorteilhaft aus Zylindern mit einem Durchmesser von 200 bis 300 Nanometern, vorzugsweise etwa 250 Nanometern, mit einer Höhe von 50 bis 90 Nanometern, vorzugsweise etwa 70 Nanometern, die vorzugsweise in einem orthogonalen Muster mit einem Abstand von 400 bis 600 Nanometern, vorzugsweise etwa 525 Nanometern angeordnet sind und einen Abstand zur Absorberschicht von 5 bis 13 Nanometern, vorzugsweise von etwa 9 Nanometern, aufweisen.

Hiermit ergeben sich optimale Bedingungen bezüglich einer Ultradünnschichtsolarzelle.

Bei der Ultradünnschichtsolarzelle kann es sich beispielsweise um eine Zelle etwa mit einer Dicke in der Größenordnung von bis zu etwa 1000 Nanometern, bspw. mit einer Rückkontaktschicht aus Silber und einer Stärke von 200 Nanometern, einer Absorberschicht aus Silizium mit einer Stärke von etwa 150 Nanometern, einer AR-Schicht etwa aus Siliziumnitrid mit einer Stärke von etwa 45 Nanometern und einer Schutzschicht aus Siliziumdioxid mit einer Stärke von etwa 64 Nanometern, handeln.

Gemäß einer weiteren Ausgestaltung der Erfindung wird die Photozelle als Solarzelle mit einer Absorptionserhöhung ausgewählter Frequenzbereiche einfallender Strahlung verwendet.

Es lassen sich also insbesondere in Abhängigkeit von der Dicke der Solarzelle eine Absorptionserhöhung bezüglich ausgewählter Frequenzbereiche einfallender Strahlung verwirklichen, um etwa IR-Anteile, die teilweise ungenutzt sind, verstärkt zu nutzen, so dass sich eine insgesamt gleichmäßige Ausnutzung der Strahlung über das gesamte Frequenzband des einfallenden Lichtes ergibt.

Gemäß einer weiteren Ausgestaltung der Erfindung wird die Photozelle als Sensor verwendet, mit einer Absorptionserhöhung ausgewählter Frequenzbereiche und/oder einer optischen Signalschwächung über einen bestimmten Frequenzbereich.

In Abhängigkeit von den gewählten Parametern der nanostrukturierten Schicht lassen sich die Eigenschaften in weiten Grenzen variieren, um bestimmte Absorptionserhöhungen ausgewählter Frequenzbereiche zu erhalten, also um etwa besondere Verstärkungen in einzelnen Frequenzbereichen zu bewirken. Umgekehrt können auch optische Signalschwächungen über einen bestimmten Frequenzbereich, also optische Filterfunktionen, erreicht werden.

Eine erfindungsgemäße Photozelle kann vorteilhaft hergestellt werden, indem die Photozelle mit einem Absorber und mit einer darüber angeordneten Antireflexionsschicht (unstrukturiert) hergestellt wird, wobei die Antireflexionsschicht mit einer nanostrukturierten Schicht mit periodisch angeordneten Antennenelementen aus einem elektrisch leitfähigem Material mit einem Abstand von 1 bis 50 Nanometern zur Absorberoberfläche hergestellt wird.

Hierbei werden vorteilhaft, zumindest Form, Größe, Anordnung, Periodizität und Abstand der Antennenelemente von der Absorberfläche in Abhängigkeit vom Aufbau und den Designparametern der Photozelle angepasst, um eine gezielte Absorptionserhöhung in einem gewünschten ersten Frequenzbereich und/oder eine optische Signalschwächung über einen zweiten Frequenzbereich zu gewährleisten.

Durch eine Anpassung der Antennenelemente lassen sich sozusagen die Eigenschaften der nanostrukturierten Schicht im Hinblick auf die gewünschte Anwendung maßschneidern.

Eine Herstellung der nanostrukturierten Schicht erfolgt mit grundsätzlich bekannten Verfahren, die im Hinblick auf die gewünschte Anwendung angepasst werden.

Bei einem Verfahren zum Herstellen einer Photozelle der vorstehend beschriebenen Art umfasst die Herstellung der nanostrukturierten Schicht nach der Applikation der (unstrukturierten) Absorberschicht und einer Schutzschicht zumindest die folgenden Schritte:
- Auftragen einer Photolackschicht auf die Schutzschicht;
- Prägen der Photolackschicht mittels eines nanostrukturierten Stempels;
- Entwickeln der Photolackschicht durch Bestrahlen mittels UV-Licht zur Erzeugung einer nanostrukturierten Photolackschicht;
- Ätzen zur Erzeugung von Vertiefungen;
- flächiges Beschichten der nanostrukturierten Schicht mit einem elektrisch leitfähigen Material;
- Entfernen der Photolackschicht.

Es handelt sich hierbei um das Herstellen der nanostrukturierten Schicht durch ein Nano-Imprint-Verfahren, nämlich die sog. Nanoprägelithographie. Hierbei wird ein weicher Prägestempel bei Raumtemperatur verwendet. Die Kontaktkraft ist kleiner als 1000 Newton. Bei der Entwicklung der Photolackschicht wird UV-Licht mit einem Wellenlängenbereich von 350 bis 450 Nanometer verwendet. Es lassen sich Auflösungen von < 15 Nanometer erzielen und Substrate von 10 bis 200 mm bearbeiten. Es handelt sich um die sog. UV-Nano-Imprint-Lithographie (UV-NIL).

Alternativ kann etwa die sog. Nano-Interferenz-Lithographie verwendet werden, um die Strukturierung der Photolackschicht zu erzeugen.

Die übrigen Schritte entsprechen den zuvor erwähnten Schritten, nämlich:
- Ätzen zur Erzeugung von Vertiefungen in der Antireflexionsschicht;
- flächiges Beschichten der nanostrukturierten Schicht mit dem elektrisch leitfähigen Material;
- Entfernen der Photolackschicht.

Es handelt sich hierbei um das Herstellen der nanostrukturierten Schicht durch ein Nano-Imprint-Verfahren, nämlich die sog. Nanoprägelithographie. Hierbei wird ein weicher Prägestempel bei Raumtemperatur verwendet. Die Kontaktkraft ist kleiner als 1000 Newton. Bei der Entwicklung der Photolackschicht wird UV-Licht mit einem Wellenlängenbereich von 350 bis 450 Nanometer verwendet. Es lassen sich Auflösungen von < 15 Nanometer erzielen und Substrate von 10 bis 200 mm bearbeiten. Es handelt sich um die sog. UV-Nano-Imprint-Lithographie (UV-NIL).

Alternativ kann etwa die sog. Nano-Interferenz-Lithographie verwendet werden, um die Strukturierung der Photolackschicht zu erzeugen.

Die übrigen Schritte entsprechen den zuvor erwähnten Schritten, nämlich:
- Ätzen zur Erzeugung von Vertiefungen in der Antireflexionsschicht;
- flächiges Beschichten der nanostrukturierten Schicht mit dem elektrisch leitfähigen Material;
- Entfernen der Photolackschicht.

Grundsätzlich erfolgt die Erzeugung der nanostrukturierten Schicht vorteilhaft an bereits fertig produzierten Solarzellen, bei denen lediglich die Antireflexionsschicht unstrukturiert hergestellt wurde, d.h. als durchgehende Schicht ohne Pyramidenstruktur.

Auf diese Weise müssen die bekannten Herstellungsprozesse bei der Herstellung der Solarzellen nicht geändert werden. Die nanostrukturierte Schicht kann also nachträglich erzeugt werden und anschließend wieder durch Auftragen einer Schutzschicht, die vorzugsweise aus Siliziumdioxid besteht, wieder versiegelt werden.

Auf diese Weise lässt sich die Herstellung der nanostrukturierten Schicht ohne großen Aufwand an bereits vorhandene Herstellprozesse anpassen.

Es versteht sich, dass die vorstehend genannten und die nachstehend noch zu erläuternden Merkmale der Erfindung nicht nur in der jeweils angegebenen Kombination, sondern auch in anderen Kombinationen oder in Alleinstellung verwendbar sind, ohne den Rahmen der Erfindung zu verlassen.

Weitere Merkmale und Vorteile der Erfindung ergeben sich aus der nachfolgenden Beschreibung bevorzugter Ausführungsbeispiele unter Bezugnahme auf die Zeichnungen. Es zeigen:
- Fig. 1: einen vereinfachten Querschnitt durch eine erfindungsgemäße Solarzelle;
- Fig. 2a bis c: verschiedene Schritte bei der Durchführung des UV-Nano-Lithographie-Verfahrens zur Erzeugung der nanostrukturierten Schicht;
- Fig. 3a bis: 3s verschiedene Konfigurationen und räumliche Anordnungen der Antennenelemente und
- Fig. 4a bis 4l: eine Zusammenfassung verschiedener Simulationsergebnisse zur Berechnung der Absorptionserhöhung in Abhängigkeit von der Wellenlänge bei ausgewählten Konfigurationen von Antennenelementen.

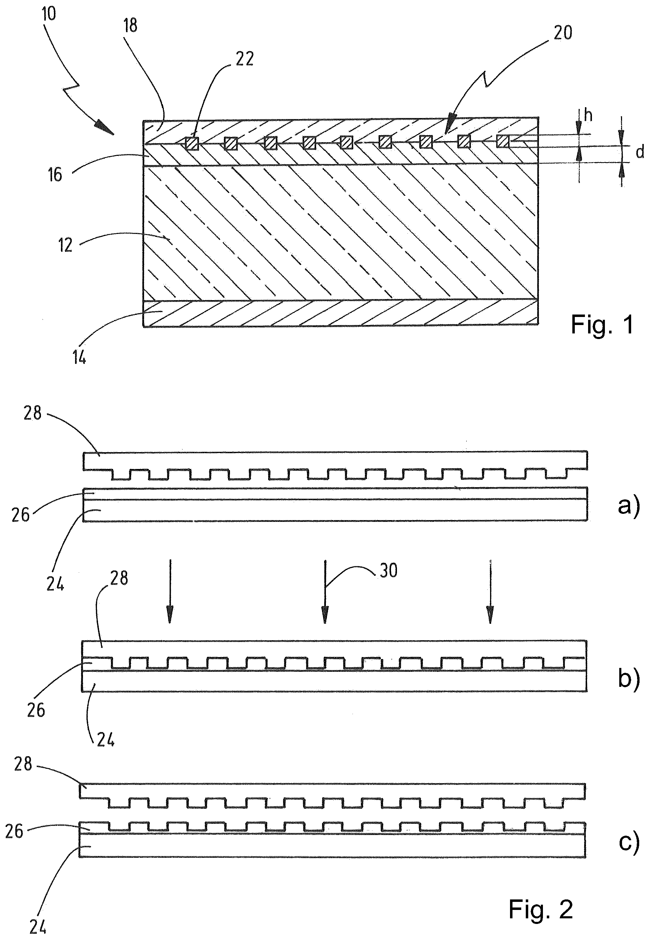

In Fig. 1 ist eine Photozelle, die hier als Solarzelle ausgebildet ist, insgesamt mit der Ziffer 10 bezeichnet. Es handelt sich hierbei z.B. um eine Standard-Dickschicht-Solarzelle aus (monokristallinem) Silizium mit einer Absorberschicht 12, einer Rückkontaktschicht 14 aus Silber, einer frontseitigen Antireflexionsschicht 16 aus Siliziumnitrid (Si₃N₄) und darüber einer Schutzschicht aus Siliziumdioxid. Zusätzlich ist eine nanostrukturierte Schicht 20 mit Antennenelementen 22 in der AR-Schicht 16 teilweise aufgenommen und steht teilweise in die Schutzschicht 18 hervor. Die nanostrukturierte Schicht 20 weist eine Höhe h auf und einen Abstand d von der Absorberschicht 12.

Die einzelnen Antennenelemente können etwa aus Silber, jedoch auch aus einem anderen Material, wie Kupfer, Aluminium, Gold bzw. Legierungen davon bestehen und können ggf. auf Seite der AR-Schicht 16 oder auf der abgewandten Seite mit einem anderen Material beschichtet sein, also z.B. aus Silber bestehen und auf der AR-Seite mit Gold beschichtet sein. Form, Größe, Anordnung und weitere Parameter der Antennenelemente 22 können in weiten Grenzen variiert werden, um maßgeschneiderte Eigenschaften der nanostrukturierten Schicht im Hinblick auf die jeweilige Anwendung zu erzeugen. Die Antennenelemente 22 bilden zusammen mit dem Rückkontakt 14 einen optischen Resonator, wobei die Antennenelemente 22 als Plasmonen wirken.

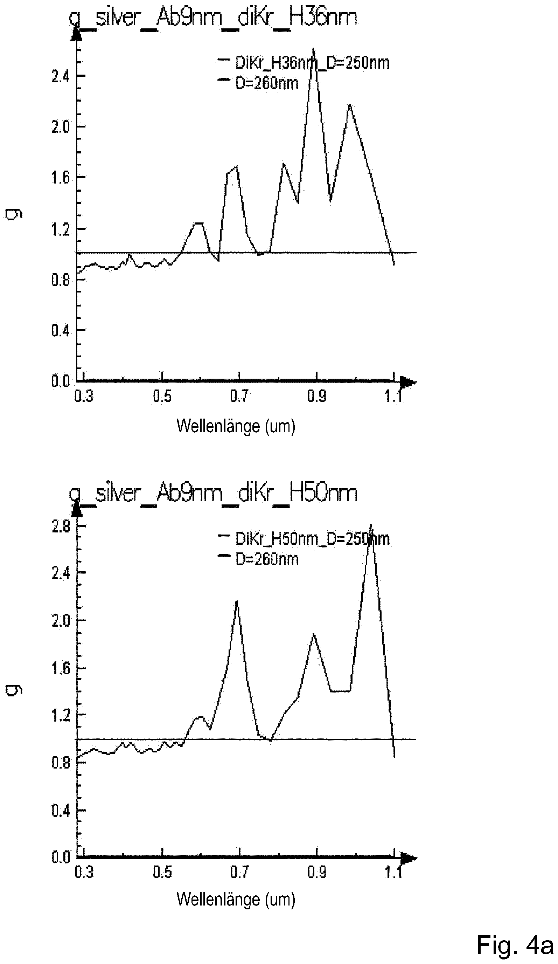

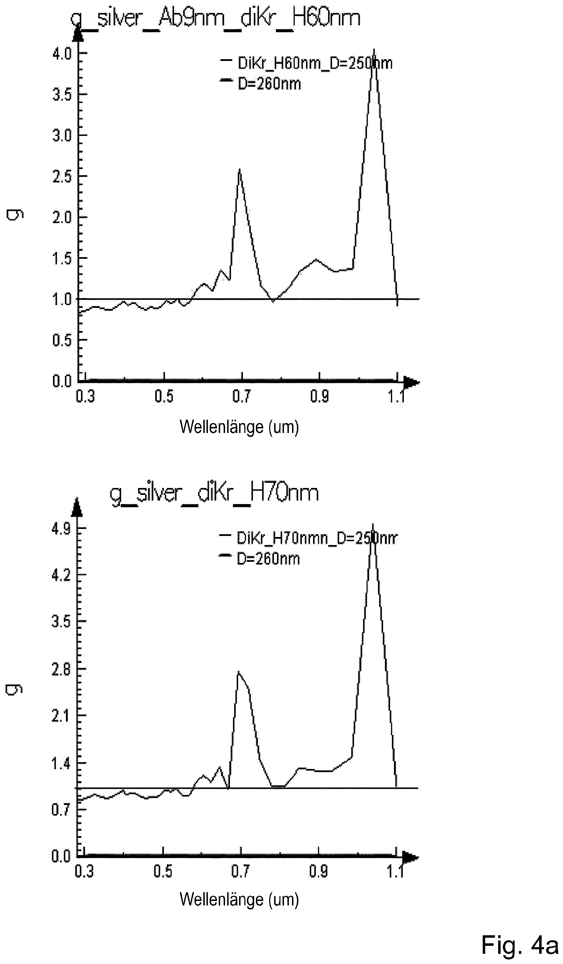

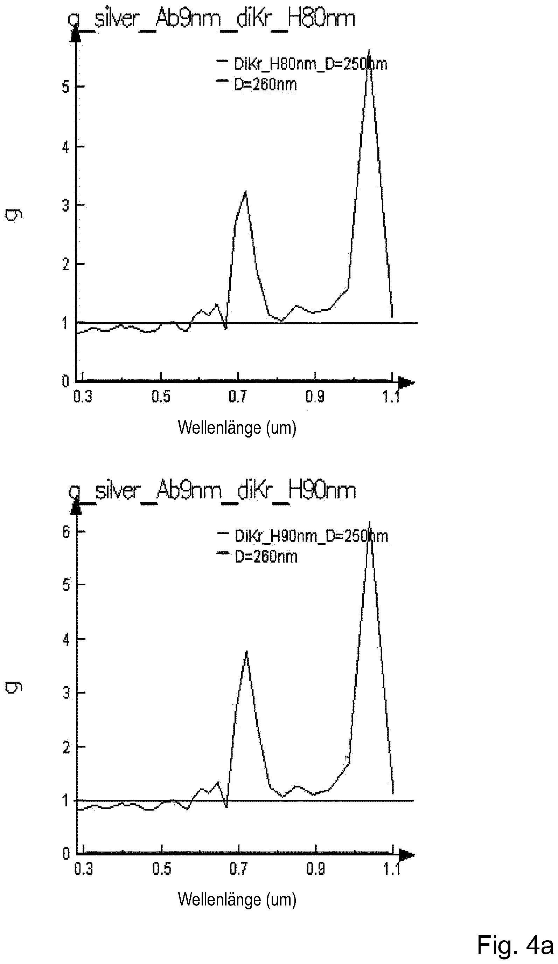

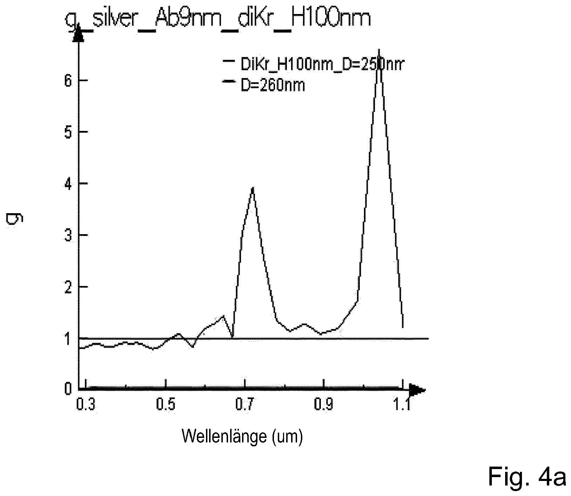

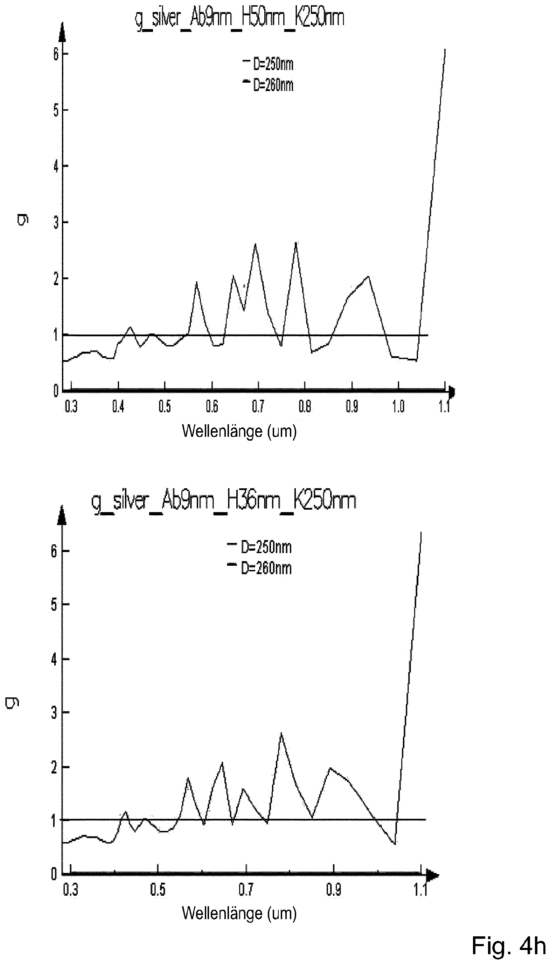

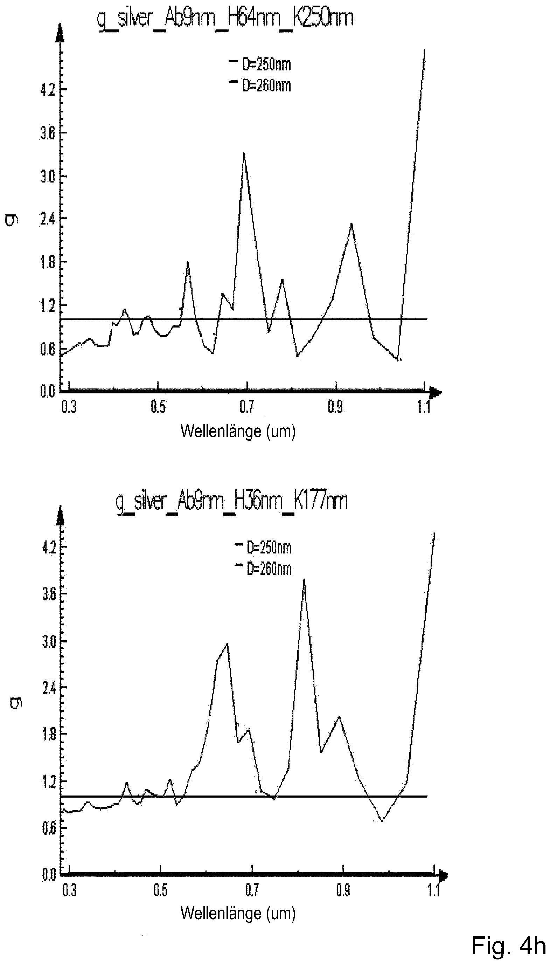

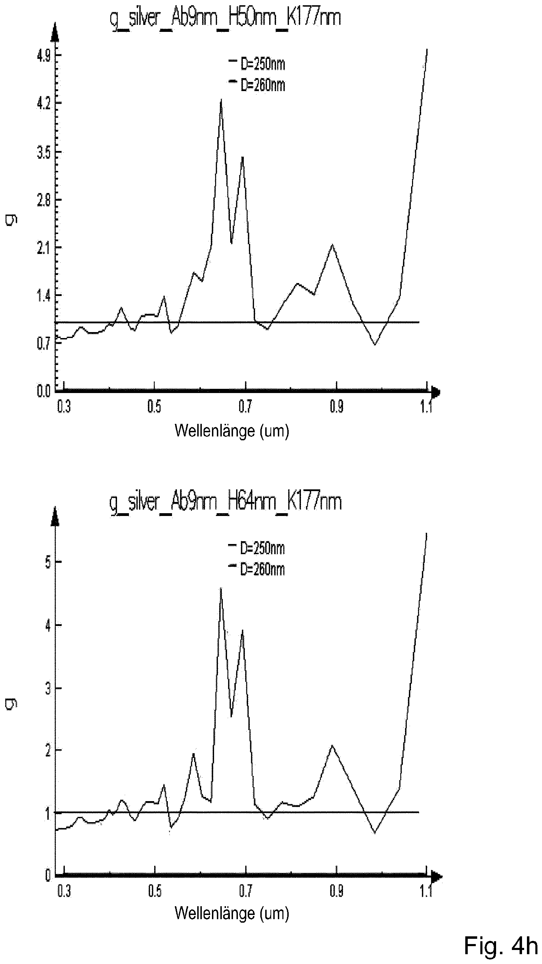

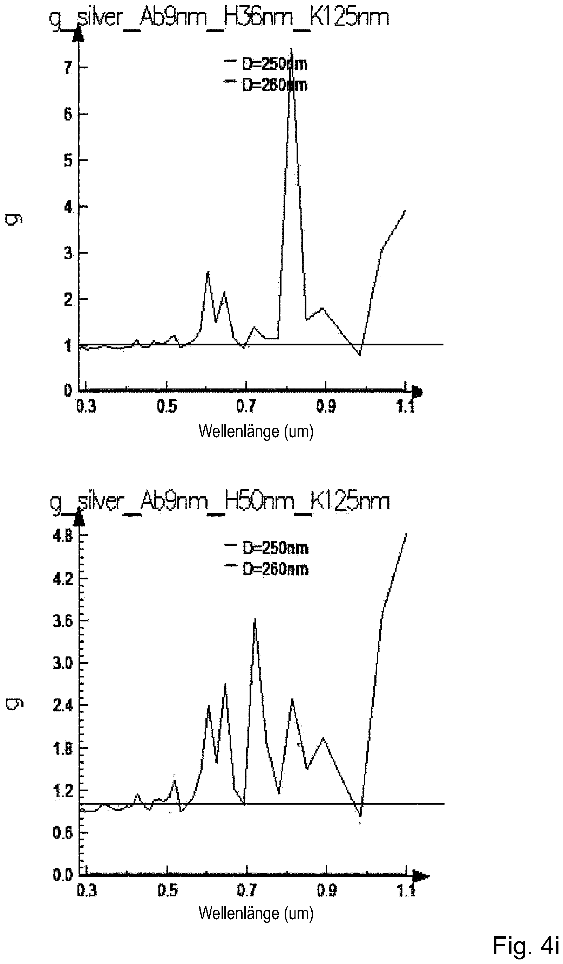

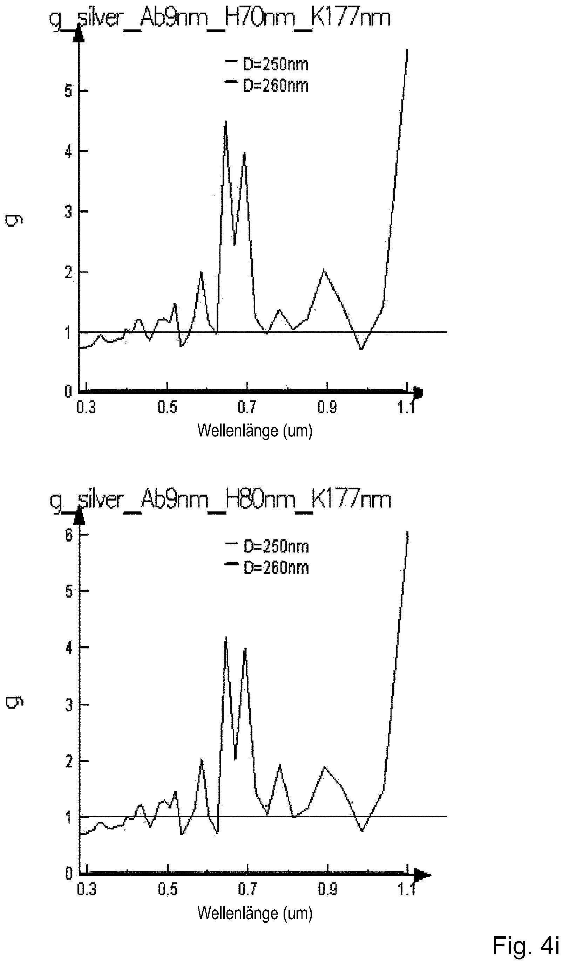

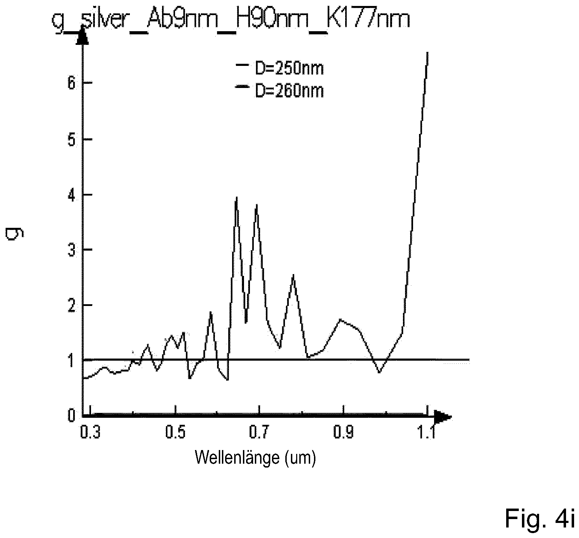

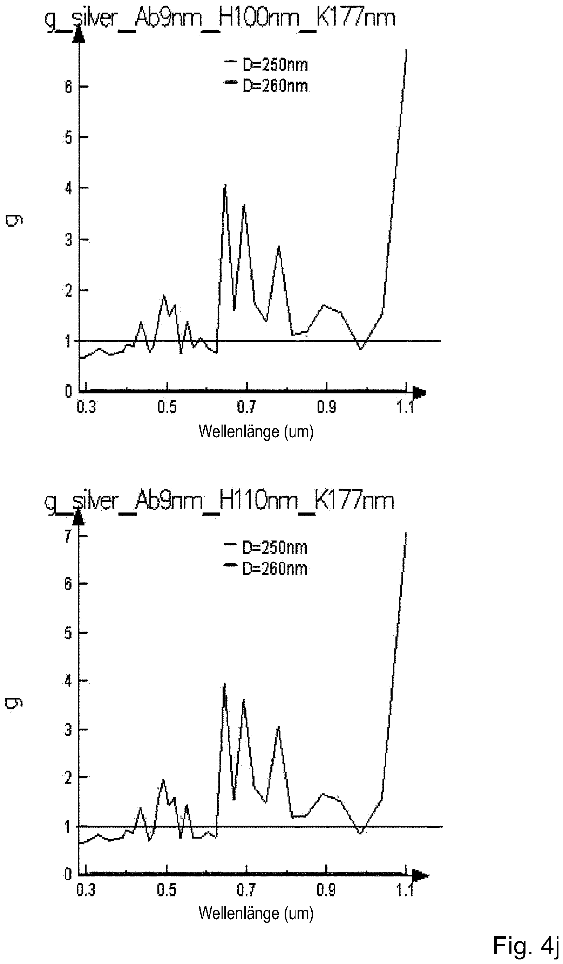

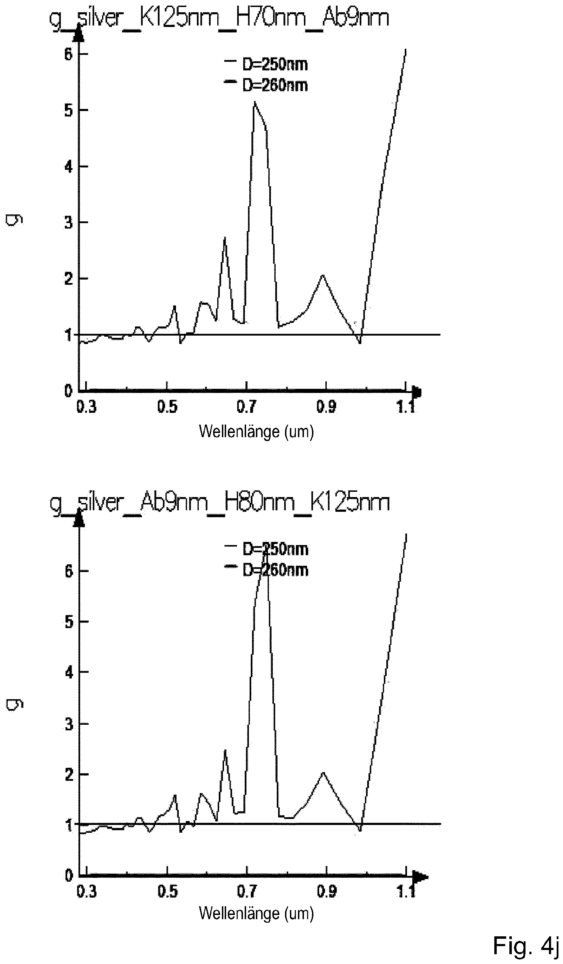

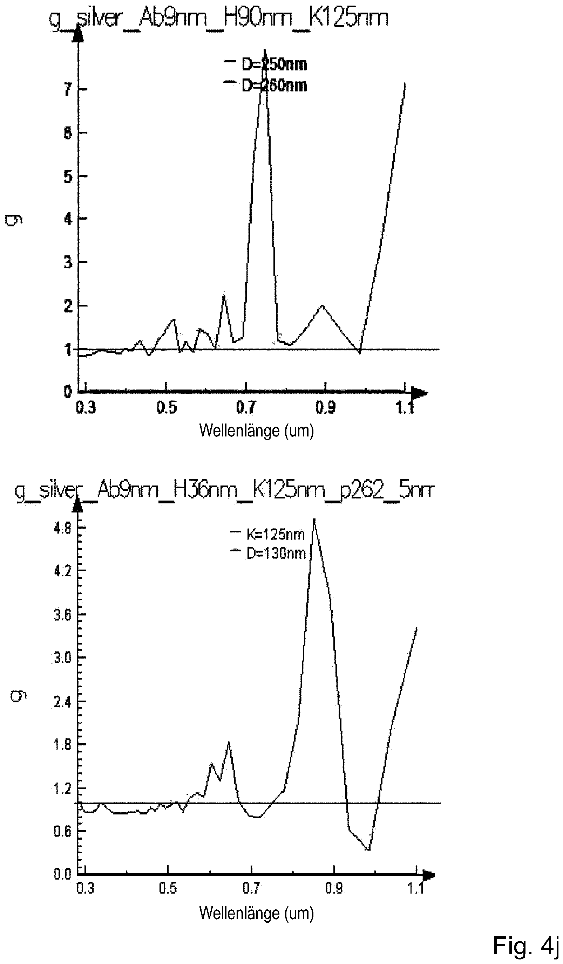

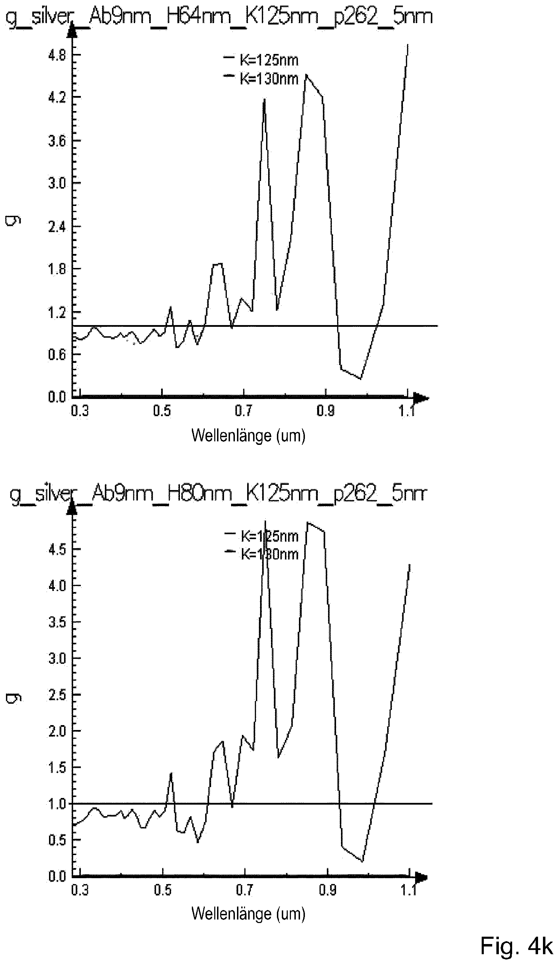

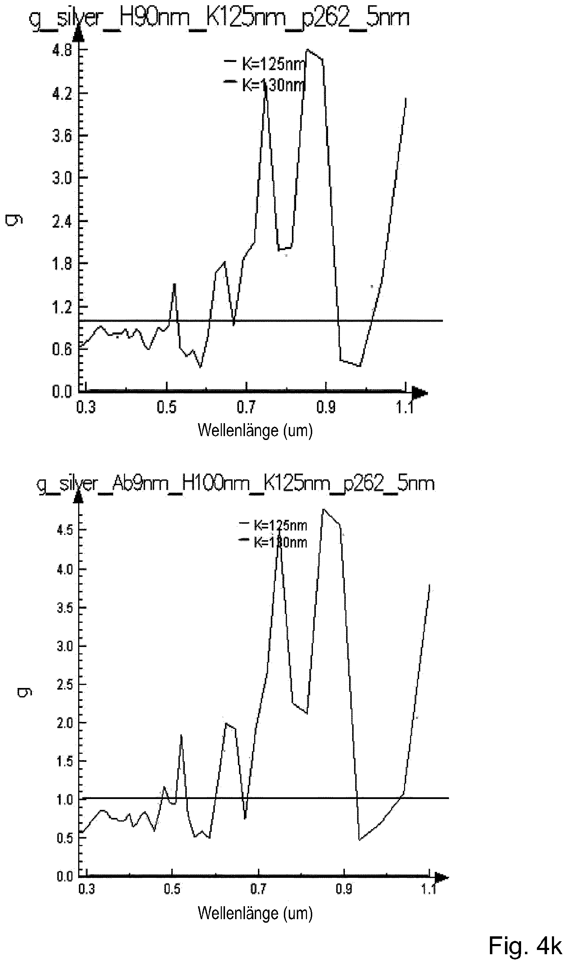

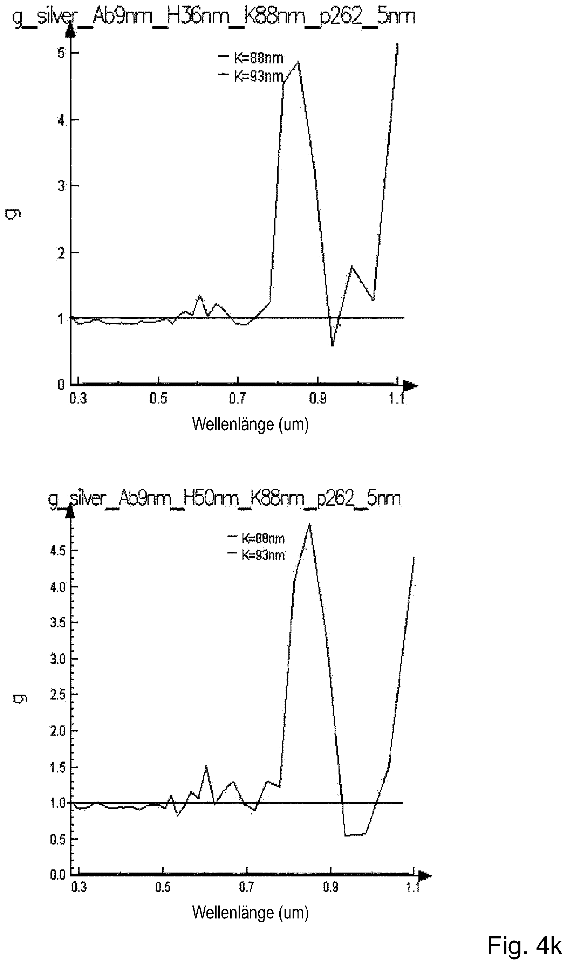

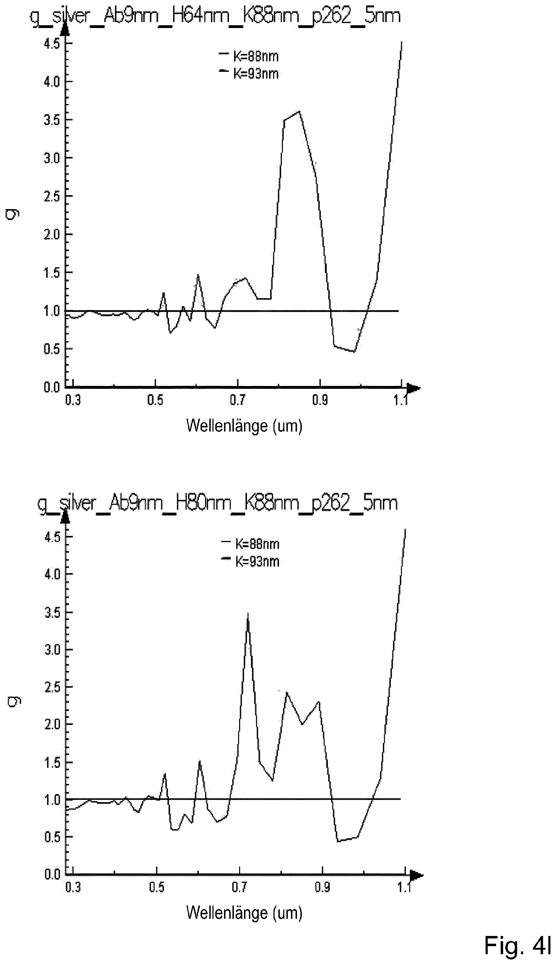

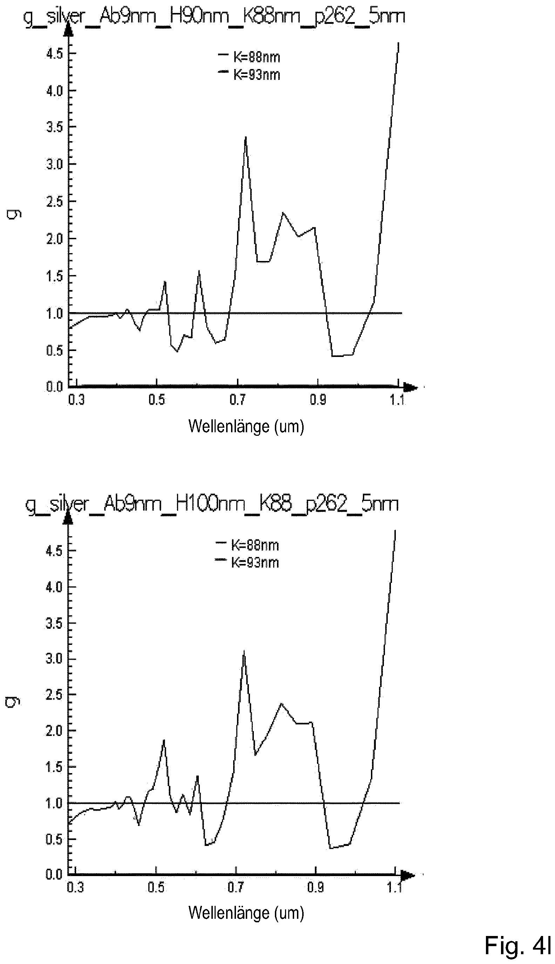

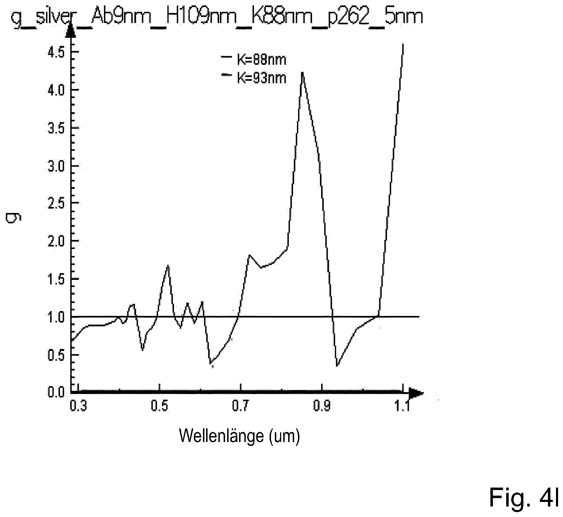

Durch die Simulation der verschiedensten Parameter kann ein optimaler Satz von Designparametern für den jeweiligen Anwendungsfall bestimmt werden. Hierbei kann die Absorptionserhöhung in Abhängigkeit von der Wellenlänge durch Simulation berechnet werden, die definiert ist als g (λ) = Absorption mit nanostrukturierter Schicht/Absorption ohne nanostrukturierte Schicht. Solange der Faktor g > 1 ist, ergibt sich also durch die nanostrukturierte Schicht eine Verbesserung der Absorption. Derartige Simulationsergebnisse sind in den Figuren 4a bis 4e beispielhaft dargestellt, auf die später noch eingegangen wird.

Grundsätzlich erfolgt die Herstellung der nanostrukturierten Schicht 20 mit im Stand der Technik bekannten Verfahren, die an die jeweilige Vorgehensweise angepasst werden. Vorzugsweise wird hierbei die Photozelle bzw. Solarzelle vollständig gemäß dem im Stand der Technik bekannten Verfahren hergestellt und erst anschließend die nanostrukturierte Schicht aufgebracht. Lediglich die Antireflexionsschicht (AR-Schicht) 16 wird als flächige Schicht erzeugt und nicht wie im Stand der Technik üblich als Pyramidenmuster strukturiert.

Der Vorteil einer nachträglichen Erzeugung der nanostrukturierten Schicht 20 besteht darin, dass die Photozelle vollständig nach bekannten Verfahren hergestellt werden kann, so dass keine Prozessänderungen erforderlich sind.

Die Herstellung der nanostrukturierten Schicht 20 gemäß dem UV-NIL-Verfahren wird im Folgenden kurz anhand von Fig. 2 erläutert.

Hierbei wird zunächst, wie vorstehend bereits erwähnt, die Solarzelle, wie im Stand der Technik bekannt, hergestellt, allerdings mit einer flächigen AR-Schicht 16. Auf der Schutzschicht 18 wird sodann eine Photolackschicht aufgetragen, bspw. durch Spin-Coating. Es ergibt sich ein Substrat 24 mit einer Photolackschicht 26 gemäß Fig. 2(a). Das Substrat 24 ist in diesem Fall die Schutzschicht 18 der Solarzelle 10 (es wäre auch denkbar, unmittelbar nach der Applikation der AR-Schicht 16 vor der Applikation der Schutzschicht 18 zu beginnen). Die Photolackschicht 26 wird anschließend mittels eines Stempels 28, der das Muster der nanostrukturierten Schicht 20 aufweist, strukturiert. Der weiche, aus Gummi bestehende Stempel 28 wird gemäß Fig. 2(b) bei Raumtemperatur mit einer Kontaktkraft von < 1000 Newton auf die Photolackschicht 26 aufgepresst, wie durch die Pfeile 30 in Fig. 2(b) angedeutet ist. Dadurch wird die Struktur des Stempels 28 auf die Photolackschicht 26 übertragen. Durch eine UV-Bestrahlung mit Licht von etwa 350 bis 450 Nanometern wird während dieses Schrittes gemäß Fig. 2(b) die Photolackschicht 26 ausgehärtet. Nach dem Abheben des Stempels 28 gemäß Fig. 2(c) verbleibt das Substrat 24 mit der nanostrukturierten Photolackschicht 26 an seiner Oberfläche.

Anschließend erfolgt eine weitere Behandlung durch Ätzen (Trockenätzen), anschließend flächiges Beschichten mit der gewünschten Metallschicht, z.B. Silber, schließlich Entfernen der Photolackschicht. Es verbleibt die nanostrukturierte Schicht 20 mit den diskreten Antennenelementen 22 in der gewünschten Anordnung, mit dem gewünschten Abstand zur Absorberschicht 12. Je nach Verfahrensführung beim Ätzen, bei der Beschichtung und je nach Tiefe der aufgebrachten Einprägungen mit dem Stempel in die Photolackschicht, lässt sich die nanostrukturierte Schicht mit den gewünschten Designparametern erzeugen. Je nach Höhe der einzelnen Antennenelemente 22 stehen diese entweder aus der AR-Schicht 16 nach oben hervor, oder sind vollständig darin aufgenommen. Als abschließender Schritt erfolgt dann die Applikation einer Schutzschicht auf der Oberfläche, in der Regel Siliziumdioxid.

Bei der obigen Darstellung wurde auf die Darstellung der Kontaktfinger an der Vorderseite der Solarzelle verzichtet, da diese in der üblichen Weise gemäß dem jeweiligen Herstellungsverfahren der Solarzelle 10 erzeugt werden.

Gegenstand der Erfindung ist nicht das Herstellverfahren für die nanostrukturierte Schicht 20 als solche, sondern es geht im Wesentlichen um Aufbau, Anordnung und Design der nanostrukturierten Schicht.

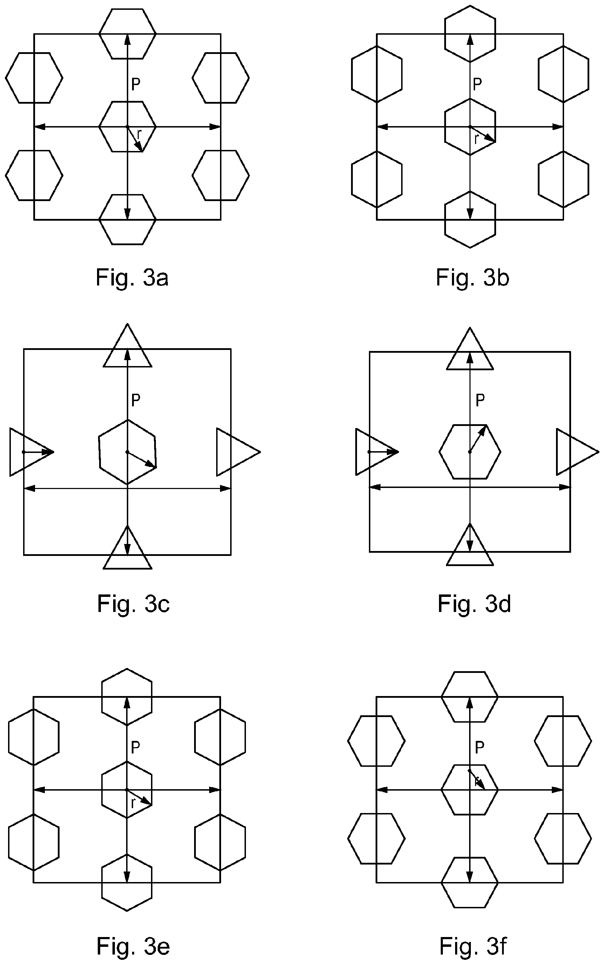

In den Figuren 3a bis 3s sind eine Reihe von Designvarianten von Antennenelementen 22 dargestellt. Gezeigt ist jeweils die Aufsicht auf eine Elementarzelle (Periode P).

Es sei darauf hingewiesen, dass in allen beschriebenen Fällen die jeweiligen Antennenelemente sich geradlinig in Richtung der Höhe erstrecken, d.h., dass es sich also um gerade Zylinder bzw. Prismen handelt.

In Fig. 3a und 3b sind hexagonale Anordnungen von hexagonalen Antennenelementen gezeigt. Gemäß Fig. 3a stehen die Seitenflächen zueinander parallel, während gemäß Fig. 3b jeweils die Ecken zueinander zeigen.

In den Figuren 3c und 3d sind Kombinationen eines hexagonalen Antennenelementes in der Mitte mit jeweils einem Dreieck in orthogonaler Anordnung gezeigt. Gemäß Fig. 3c zeigt die Spitze des Hexagons zu den Dreiecken, während gemäß Fig. 3d die Seitenflächen eines Hexagons zu den Dreiecken zeigt.

Fig. 3e und 3f entsprechen Fig. 3b bzw. 3a.

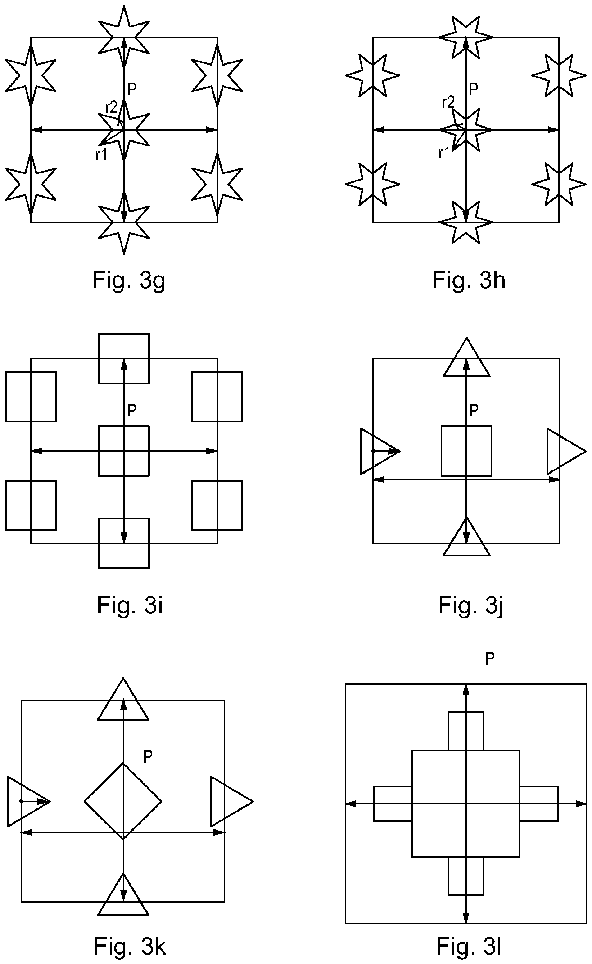

In den Figuren 3g und 3h sind sternförmige Antennenelemente gezeigt, wobei Fig. 3g eine hexagonale Anordnung zeigt, wobei die Spitze der sternförmigen Antennenelemente zueinander zeigen. Dagegen zeigen gemäß Fig. 3h die Seiten der sternförmigen Antennenelemente zueinander.

Fig. 3i zeigt eine hexagonale Anordnung von quadratischen Antennenelementen.

In den Figuren 3j und 3k finden sich Kombinationen von einem Quadrat und von Dreiecken, jeweils mit einem Quadrat in der Mitte und Dreiecken auf den Seitenflächen in orthogonaler Anordnung. Gemäß Fig. 3j ist das Quadrat mit seinen Seitenflächen parallel zur Elementarzelle angeordnet, gemäß Fig. 3k ist das Quadrat um 45° gedreht, so dass die Spitzen zu den Dreiecken zeigen.

In den Figuren 3l bis 3p sind verschiedene Kreuzstrukturen dargestellt. Es handelt sich jeweils um orthogonale Anordnungen. Gemäß Fig. 3l ist in der Mitte der Elementarzelle ein großes Quadrat, wobei an den Seitenflächen des großen Quadrates jeweils kleine Quadrate in symmetrischer Anordnung aufgebracht sind.

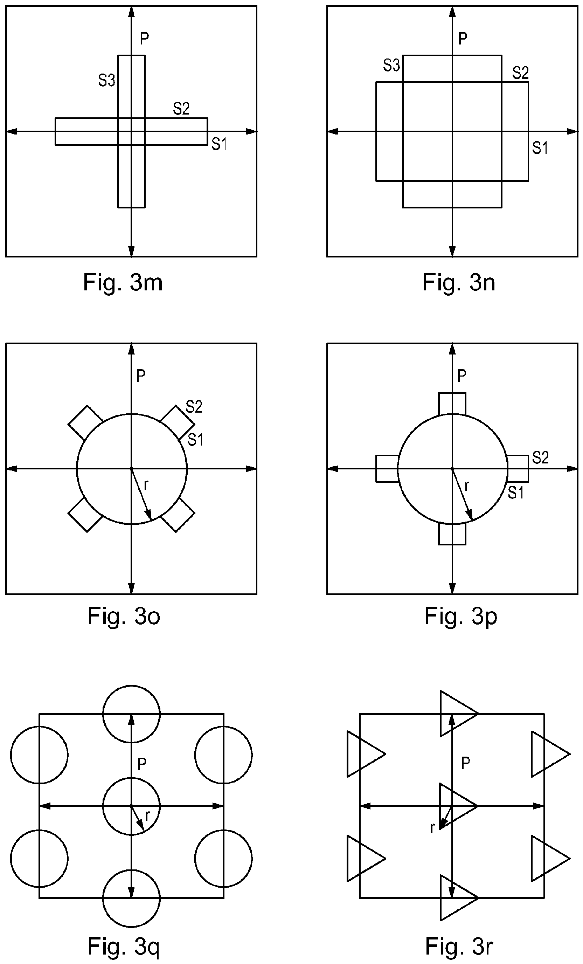

Fig. 3m zeigt eine Kreuzstruktur aus zwei miteinander gekreuzten Balken.

Fig. 3n zeigt eine Kreuzstruktur mit einem großen Quadrat, an dessen Ecken jeweils kleine Quadrate ausgeschnitten sind.

Fig. 3o zeigt eine Kreuzstruktur mit einem zentralen Kreis, auf den in Winkelabständen von 90° zueinander auf die Außenseite jeweils kleinere Rechtecke aufgesetzt sind. Gemäß Fig. 3o sind die Rechtecke um 45° verdreht und zeigen somit zu den Ecken der Elementarzelle. Gemäß Fig. 3p zeigen die aufgesetzten Rechtecke parallel zur Seitenfläche der Elementarzelle.

Fig. 3q zeigt eine hexagonale Anordnung von Zylindern.

Fig. 3r zeigt eine hexagonale Anordnung von gleichseitigen Dreiecken.

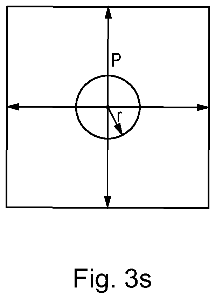

Fig. 3s zeigt Zylinder in orthogonaler Anordnung.

Die verwendeten Designparameter sind in Tabelle 1 zusammengefasst. Hierbei wird jeweils Bezug genommen auf die betreffende Figur.

**Tabelle 1**

| **Serie 1:** | **Hexagon Seitenflächen stehen zueinander parallel (****Fig. 3a****)** |
|---|---|
| Anordnung: | Hexagon (regelmäßig) |
| Periode (P): | 460 nm |
| Radius (r): | 125 nm |
| Abstand (d): | 9 nm |
| Material: | Silber (Ag) |
| Variiert: Höhe (h) von 36 nm bis 90 nm (36, 50, 64, 70, 80, 90 nm) | |

| **Serie 2:** | **Hexagon Ecken zeigen zueinander (****Fig. 3b****)** |
|---|---|
| Anordnung: | Hexagonal |
| Form: | Hexagon (regelmäßig) |
| Periode (P): | 460 nm |
| Radius (r): | 125 nm |
| Abstand (d): | 9 nm |
| Material: | Silber (Ag) |
| Variiert: | |
| Höhe (h) der Struktur von 36 nm bis 90 nm (36, 50, 64, 70, 80, 90 nm) | |

| **Serie 3:** | **Hexagon und Dreieck (****Fig. 3c****)** |
|---|---|
| Anordnung: | Orthogonal |
| Form: | Hexagon und Dreieck |
| Periode (P): | 300 nm und 600 nm |
| Radius Hexagon: | 125,0 nm |
| Radius Dreieck: | 72,5 nm |
| Höhe (h): | 50,0 nm |
| Abstand (d): | 9,0 nm |
| Material: | Silber (Ag) |

| **Serie 3:** | **Hexagon (gedreht) und Dreieck (****Fig. 3d****)** |
|---|---|
| Anordnung: | Orthogonal |
| Form: | Hexagon und Dreieck |
| Periode (P): | 300 nm und 600 nm |
| Radius Hexagon: | 125,0 nm |
| Radius Dreieck: | 72,5 nm |
| Höhe (h): | 50,0 nm |
| Abstand (d): | 9,0 nm |
| Material: | Silber (Ag) |

| **Serie 4:** | **Hexagon mit kleinerem Radius als bei Serie 2 Ecken zeigen zueinander (****Fig. 3e****)** |
|---|---|
| Anordnung: | Hexagonal |
| Form: | Hexagon (regelmäßig) |
| Periode (P): | von 260 bis 460 nm |
| Radius (r): | 62,5 nm |
| Abstand (d): | 9,0 nm |
| Material: | Silber (Ag) |
| Variiert: | |

| Höhe (h) der Struktur von 36 nm bis 109 nm (36, 50, 64, 70, 80, 109 nm) | |
|---|---|
| **Serie 5:** | **Hexagon mit kleinerem Radius als bei Serie 2 Seitenflächen stehen zueinander parallel (****Fig. 3f****)** |
| Anordnung: | Hexagonal |
| Form: | Hexagon (regelmäßig) |
| Periode (P): | von 260 bis 460 nm |
| Radius (r): | 62,5 nm |
| Abstand (d): | 9,0 nm |
| Material; | Silber (Ag) |
| Variiert: | |
| Höhe (h) der Struktur von 36 nm bis 100 nm (36, 50, 64, 70, 80, 100 nm) | |
| **Serie 6:** | **Stern (6 Zacken), Ecken zeigen zueinander (****Fig. 3g****)** |
| Anordnung: | Hexagonal |
| Form: | Hexagon (regelmäßig) |
| Periode (P): | von 265,5 bis 460 nm |
| Radius (r): | 125 nm (r1), 62,5 nm (r2) |
| Abstand (d): | 9 nm |
| Material: | Silber (Ag) |
| Variiert: | |
| Höhe (h) von 36 nm bis 64 nm (36, 50, 64 nm) | |

| **Serie 7:** | **Stern (6 Zacken), Seiten zeigen zueinander (****Fig. 3h****)** |
|---|---|
| Anordnung: | Hexagonal |
| Form: | Hexagon (regelmäßig) |
| Periode (P): | von 265,5 bis 460 nm |
| Radius (r): | 125 nm (r1), 62,5 nm (r2) |
| Abstand (d): | 9 nm |
| Material: | Silber (Ag) |
| Variiert: | |
| Höhe (h) von 36 nm bis 64 nm (36, 50, 64 nm) | |

| **Serie 8:** | **Quadrat Seitenflächen stehen zueinander parallel (****Fig. 3i****)** |
|---|---|
| Anordnung: | Hexagonal |
| Form: | Quadrat |
| Periode (P): | 262,5 bis 400 nm |
| Abstand (d): | 9 nm |
| Material: | Silber (Ag) |
| Variiert: | |
| Kantenlänge: 88 nm bis 250 nm (88, 125, 177, 250 nm) | |
| Höhe (h) von 36 nm bis 110 nm (36, 50, 60, 64, 70, 80, 90, 100, 110 nm) | |

| **Serie 9:** | **Quadrat und Dreieck (****Fig. 3j****)** |
|---|---|
| Anordnung: | Orthogonal |
| Form: | Quadrat und Dreieck |
| Periode (P): | 380 und 520 nm |
| Kantenlänge: | 177,0 nm |
| Radius Dreieck: | 72,5 nm |
| Höhe (h): | 50,0 nm |
| Abstand (d): | 9,0 nm |
| Material: | Silber (Ag) |

| **Serie 10:** | **Quadrat (gedreht) und Dreieck (****Fig. 3k****)** |
|---|---|
| Anordnung: | Orthogonal |
| Form: | Quadrat und Dreieck |
| Periode (P): | 380 nm und 520 nm |
| Kantenlänge: | 177,0 nm |
| Radius Dreieck: | 72,5 nm |
| Höhe (h): | 50,0 nm |
| Abstand (d): | 9,0 nm |
| Material: | Silber (Ag) |

| **Serie 11:** | **Kreuz-Struktur (****Fig. 3l****)** |
|---|---|
| Anordnung: | Orthogonal |
| Form: | Quadrat |
| Periode (P): | 525 nm |
| Abstand (d): | 9,0 nm |
| Material: | Silber (Ag) |
| Kantenlänge kleine Quadrate: | 50 nm |
| Kantenlänge großes Quadrat: | 150 nm |
| Variiert: | |
| Höhe (h) von 36 nm bis 100 nm (36, 50, 60, 70, 80, 90, 100 nm) | |

| **Serie 12:** | **Kreuz-Struktur (****Fig. 3m****)** |
|---|---|
| Anordnung: | Orthogonal |
| Form: | Rechteck |
| Periode (P): | 520 nm |
| Abstand (d): | 9 nm |
| Material: | Silber (Ag) |
| S1: | 63,0 nm |
| S2: | 94,5 nm |
| S3: | 94,5 nm |
| Variiert: | |
| Höhe (h) von 36 nm bis 64 nm (36, 50, 64 nm) | |

| **Serie 13:** | **Kreuz-Struktur (****Fig. 3n****)** |
|---|---|
| Anordnung: | Orthogonal |
| Form: | Rechteck |
| Periode (P): | 520 nm |
| Abstand (d): | 9 nm |
| Material: | Silber (Ag) |
| S1: | 63,0 nm |
| S2: | 94,5 nm |
| S3: | 94,5 nm |
| Variiert: | |
| Höhe (h) von 36 nm bis 64 nm (36, 50, 64 nm) | |

| **Serie 14:** | **Kreuz-Struktur (****Fig. 3o****)** |
|---|---|
| Anordnung: | Orthogonal |
| Form: | Rechteck, Kreis |
| Periode (P): | 500 nm |
| Abstand (d): | 9 nm |
| Material: | Silber (Ag) |
| S1: | 50 nm |
| S2: | 50 nm |
| r: | 123 nm |
| Variiert: | |
| Höhe (h) von 36 nm bis 100 nm (36, 50, 64, 80, 90, 100 nm) | |

| **Serie 15:** | **Kreuz-Struktur (****Fig. 3p****)** |
|---|---|
| Anordnung: | Orthogonal |
| Form: | Rechteck, Kreis |
| Periode (P): | 520 nm |
| Abstand (d): | 9 nm |
| Material: | Silber (Ag) |
| S1: | 48 nm |
| S2: | 50 nm |
| r: | 125 nm |
| Variiert: | |
| Höhe (h) von 36 nm bis 100 nm (36, 50, 64, 80, 90, 100 nm) | |

| **Serie 16:** | **Zylinder (****Fig. 3q****)** |
|---|---|
| Anordnung: | Hexagonal |
| Form: | Zylinder |
| Periode (P): | 400 nm |
| Radius (r): | 125 nm |
| Höhe (h): | 40 nm |
| Material: | Silber (Ag) |
| Variiert: | |
| Abstand (d) von 6 nm bis 17 nm (6, 7, 8, 9, 10, 11, 12, 15, 16, 17 nm) | |

| **Serie 17:** | **Dreieck (****Fig. 3r****)** |
|---|---|
| Anordnung: | Hexagonal |
| Form: | Dreieck (gleichseitiges) |
| Periode (P): | 520,0 nm |
| Radius (r): | 145 nm und 72,5 nm |
| Abstand (d): | 9 nm |
| Material: | Silber (Ag) |
| Variiert: | |
| Höhe (h) von 22 nm bis 100 nm (22, 36, 50, 60, 70, 100 nm) | |

| **Serie 18:** | **Zylinder (****Fig. 3s****)** |
|---|---|
| Anordnung: | Orthogonal |
| Form: | Zylinder |
| Periode (P): | 525 nm |
| Radius (r): | 125 nm |
| Höhe (h): | 50 nm |
| Material: | Silber (Ag) |
| Variiert: | |
| Abstand (d) von 6 nm bis 17 nm (6, 7, 8, 9, 10, 11, 12, 15, 16, 17 nm) | |

| **Serie 19:** | **Zylinder (****Fig. 3s****)** |
|---|---|
| Anordnung: | Orthogonal |
| Form: | Zylinder |
| Periode (P): | 525 nm |
| Radius (r): | 125 nm |
| Höhe (h): | 50 nm |
| Beschichtete Fläche: | oben/unten |
| Dicke der Schicht: | 10 nm |
| Material: | Silber (Ag) |
| Abstand (d): | 9 nm |
| Variiert: | |
| Dielektrikum mit Brechzahl: n = 1,3 bis 1,9 (n= 1,3, 1,4, 1,6, 1,7, 1,8, 1,9) sowie Kombinationen mit Siliziumdioxid (SiO₂) oder Siliziumnitrid (Si₃N₄) | |

| **Serie 20:** | **Zylinder (****Fig. 3s****)** |
|---|---|
| Anordnung: | Orthogonal |
| Form: | Zylinder |
| Periode (P): | 525 nm |
| Radius (r): | 125 nm |
| Höhe (h): | 50 nm |
| Material: | Silber (Ag) |
| Abstand (d): | 9 nm |
| Beschichtete Fläche: | oben |
| Material: | Kupfer, Gold |
| Variiert: | |
| Dicke der Schicht: 5 nm bis 10 nm (5, 6, 7, 8, 9, 10 nm) | |

| **Serie 21:** | **Zylinder (****Fig. 3s****)** |
|---|---|
| Anordnung: | Orthogonal |
| Form: | Zylinder |
| Periode (P): | 525 nm |
| Radius (r): | 125 nm |
| Höhe (h): | 50 nm |
| Material: | Silber (Ag) |
| Abstand (d): | 9 nm |
| Beschichtete Fläche: | oben |
| Material: | Gold, Kupfer |
| Dicke der Schicht: | 7 nm |
| Variiert: | |
| Abstand (d) der Gold-/Kupferschicht von der Zylinderoberseite: 6 nm bis 16 nm (6, 8, 10, 12, 14, 16 nm) | |

| **Serie 22:** | **Zylinder mit weiteren Scheiben übereinander (****Fig. 3s****)** |
|---|---|
| Anordnung: | Orthogonal |
| Form: | Zylinder |
| Periode (P): | 525 nm |
| Radius (r): | 125 nm |
| Höhe (h): | 50 nm |
| Material: | Silber (Ag) |
| Abstand (d): | 9 nm |
| Zwei Scheiben (Zylinder) | |
| Material: | Silber (Ag) |
| Dicke der Schicht: | 6 nm und 10 nm |
| Variiert: | |
| Abstand (d) der 1. Scheibe vom Zylinderoberseite von 40 nm und 44 nm und Abstand (d) der 2. Scheibe von der 2. Scheibe von 10 nm und 28 nm (10, 19, 28 nm) | |

| **Serie 23:** | **Zylinder (****Fig. 3s****)** |
|---|---|
| Anordnung: | Orthogonal |
| Form: | Zylinder |
| Radius (r): | 125 nm |
| Höhe (h): | 70 nm |
| Material: | Silber (Ag) |
| Abstand (d): | 9 nm |
| Variiert: | |
| Periode von 375 nm bis 600 nm (375, 400, 425, 450, 475, 500, 525, 550, 575, 600 nm) | |

| **Serie 24:** | **Zylinder (****Fig. 3s****)** |
|---|---|
| Anordnung: | Orthogonal |
| Form: | Zylinder |
| Periode (P): | 525 nm |
| Radius (r): | 125 nm |
| Material: | Silber (Ag) |
| Abstand (d): | 9 nm |
| Variiert: | |
| Höhe (h) von 20 nm bis 109 nm (20, 30, 40, 50, 60, 70, 80, 90, 100, 109 nm) | |

| **Serie 25:** | **Zylinder (****Fig. 3s****)** |
|---|---|
| Anordnung: | Orthogonal |
| Form: | Zylinder |
| Periode (P): | 525 nm |
| Höhe (h): | 70 nm |
| Material: | Silber (Ag) |
| Abstand (d): | 9 nm |
| Variiert: | |
| Radius (r) von 70 nm bis 160 nm (70, 80, 90, 100, 110, 115, 120, 125, 135, 140, 150, 160 nm) | |

| **Serie 26:** | **Zylinder (****Fig. 3s****)** |
|---|---|
| Anordnung: | Orthogonal |
| Form: | Zylinder |
| Radius (r): | 95 nm |
| Höhe (h): | 70 nm |
| Material: | Silber (Ag) |
| Abstand (d): | 9 nm |
| Variiert: | |
| Periode (P) von 375 nm bis 600 nm (375, 400, 425, 450, 460, 464,75, 470, 475, 500, 525, 550, 575, 600 nm) | |

| **Serie 27:** | **Zylinder (****Fig. 3s****)** |
|---|---|
| Anordnung: | Orthogonal |
| Form: | Zylinder |
| Periode (P): | 464,75 nm |
| Radius (r): | 95 nm |
| Material: | Silber (Ag) |
| Abstand (d): | 9 nm |
| Variiert: | |
| Höhe (h) von 20 nm bis 109 nm (20, 30, 40, 50, 60, 70, 80, 90, 100, 109 nm) | |

| **Serie 28:** | **Zylinder (****Fig. 3s****)** |
|---|---|
| Anordnung: | Orthogonal |
| Form: | Zylinder |
| Periode (P): | 464,75 nm |
| Höhe (h): | 70 nm |
| Material: | Silber (Ag) |
| Abstand (d): | 9 nm |
| Variiert: | |
| Radius (r) von 50 nm bis 120 nm (50, 70, 80, 85, 90, 100, 110, 120 nm) | |

In Tabelle 1 sind weitere Simulationsergebnisse in zusätzlichen Serien 19 bis 28 zusammengefasst. Sie beziehen sich jeweils auf die Zylinder mit orthogonaler Anordnung gemäß Fig. 3s.

Ausgewählte Simulationsergebnisse betreffend die berechneten Absorptionserhöhungen g in Abhängigkeit von der Wellenlänge sind in den Figuren 4a bis 4l zusammengefasst. Wie sich aus den einzelnen Darstellungen ergibt, zeigen sich teilweise starke Absorptionserhöhungen in bevorzugten Wellenlängenbereichen. Die Eigenschaften der Plasmonen in den Antireflexionsschichten ermöglichen somit nicht nur ein verbessertes Photonen-Management, sondern unter Verwendung spezieller Designparameter kann auch eine optische Filterfunktion bzw. Signalschwächung und eine gleichzeitige Verstärkung bestimmter Frequenzbereiche erzielt werden. Somit können die Nano-Antennenelemente 22 bezüglich ihrer Designparameter entsprechend angepasst werden, um spezielle Eigenschaften im Bereich von optischen Sensoren zu bewirken.

Fig. 4a zeigt Simulationsergebnisse zur Kreuzstruktur gemäß Serie 11 gemäß Tabelle 1. Die Darstellung der Absorptionserhöhung in Abhängigkeit von der Wellenlänge zeigt zwei starke Peaks bei etwa 1050 Nanometer und 725 Nanometer mit einer bis zu 6-fachen Verstärkung. Der restliche Frequenzbereich bleibt unbeeinflusst bzw. wird nur relativ schwach verstärkt bis zu einem Bereich von ca. 550 Nanometer. Die Position der Peaks bzw. deren Höhe lassen sich durch die Designparameter beeinflussen.

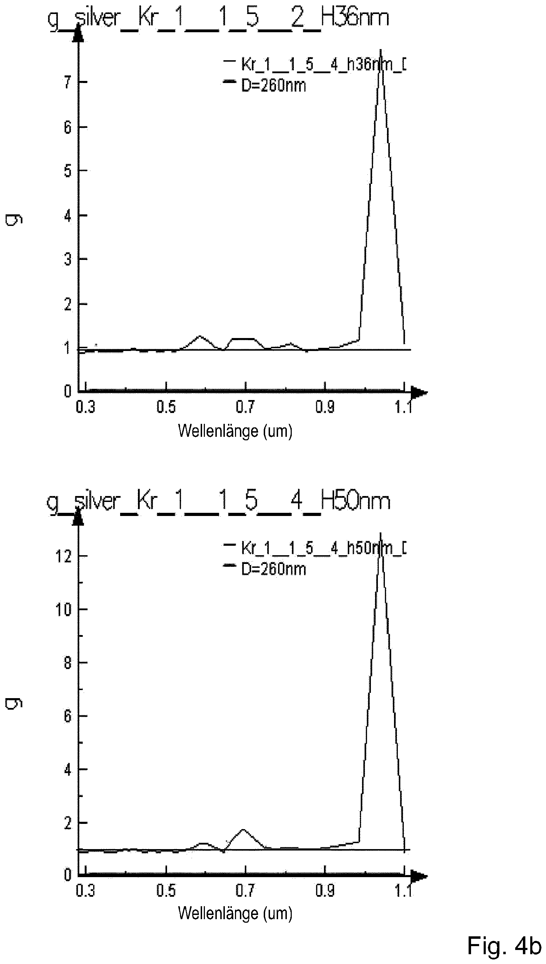

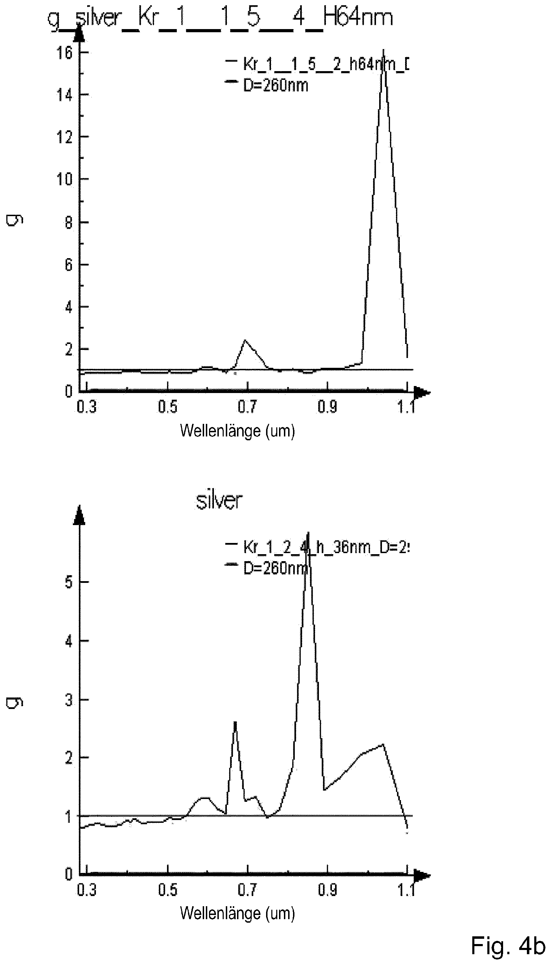

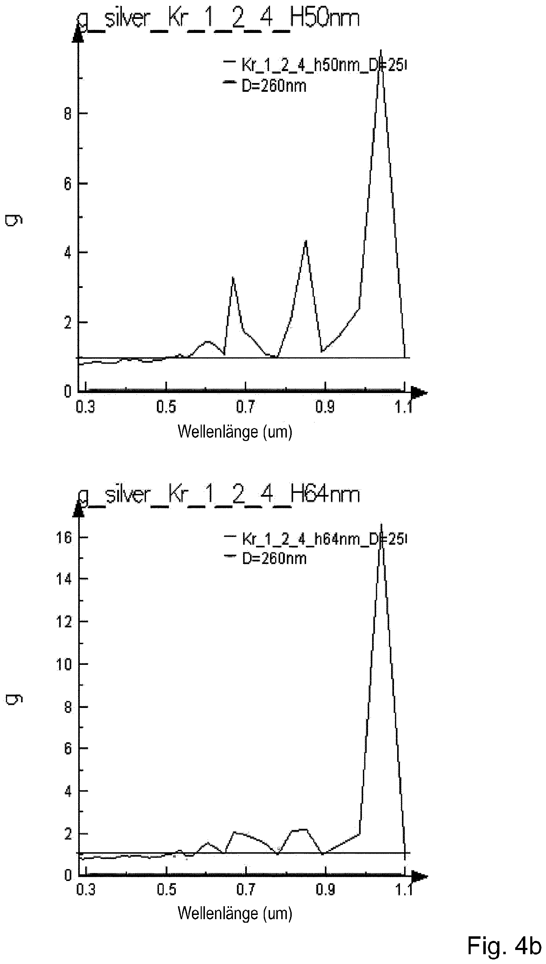

Fig. 4b zeigt Simulationsergebnisse zur Kreuzstruktur gemäß Serie 12 und 13. Es ist ersichtlich, dass zwei starke Peaks bei 1050 und 825 Nanometer vorliegen, mit einer bis zu 16-fachen Verstärkung. Der restliche Frequenzbereich bleibt unbeeinflusst bzw. wird nur relativ schwach verstärkt. Die Position der Peaks bzw. deren Höhe lässt sich durch die Designparameter beeinflussen.

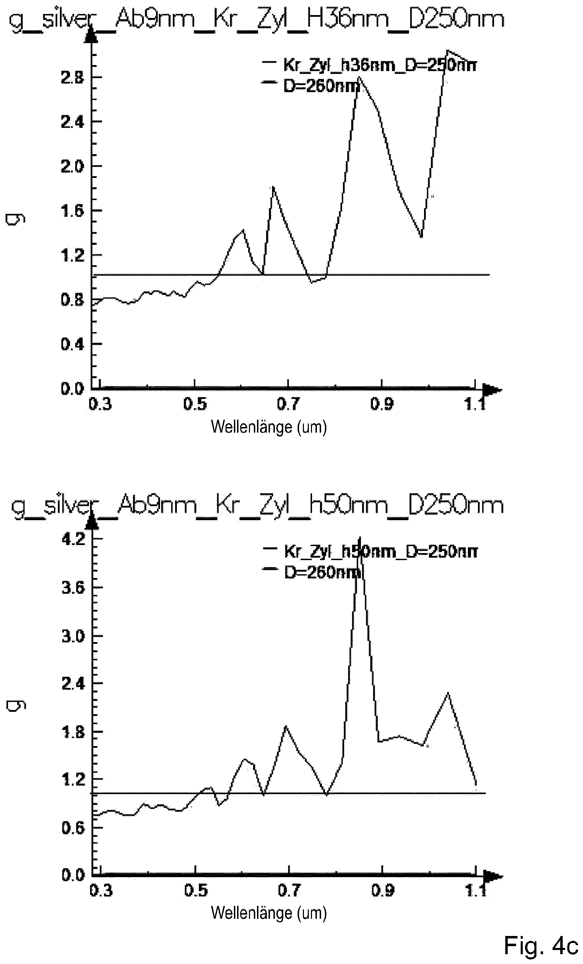

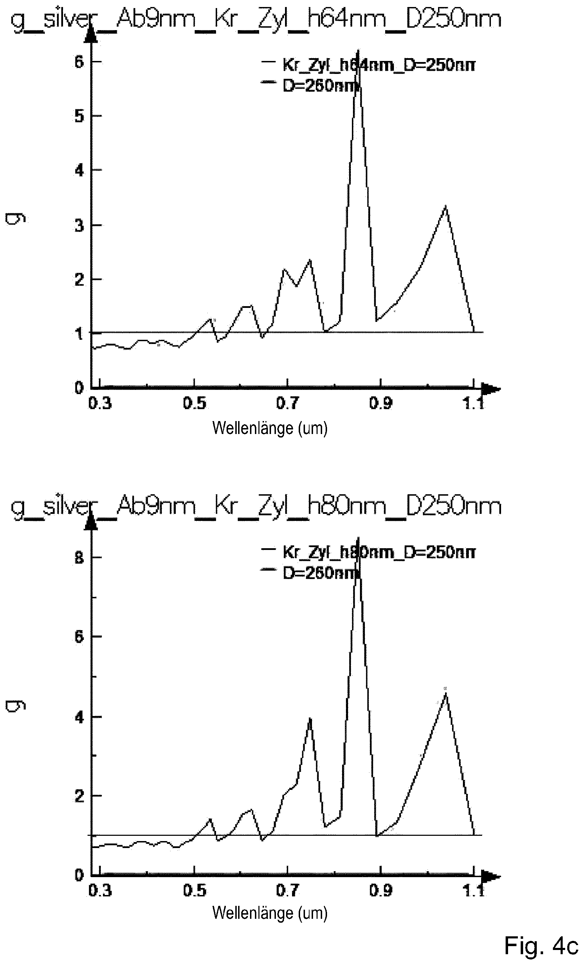

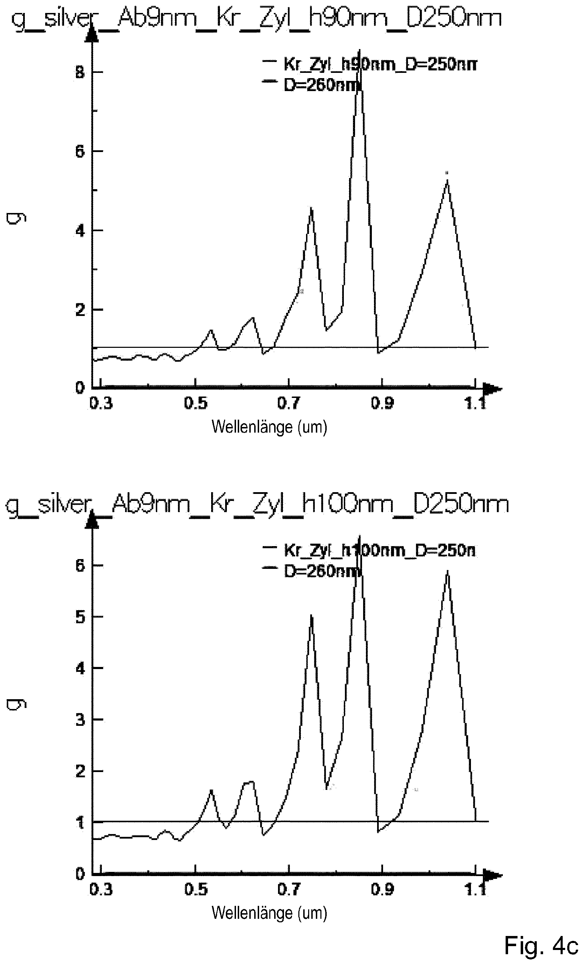

Fig. 4c zeigt weitere Simulationsergebnisse zur Kreuzstruktur gemäß Serie 16. Man sieht zwei starke Peaks bei etwa 1050 Nanometer und 725 Nanometer mit einer bis zu 6-fachen Verstärkung. Der restliche Frequenzbereich bleibt unbeeinflusst bzw. wird nur relativ schwach verstärkt bis zu einem Bereich von ca. 550 Nanometer. Die Position der Peaks bzw. deren Höhe lassen sich durch die Designparameter beeinflussen.

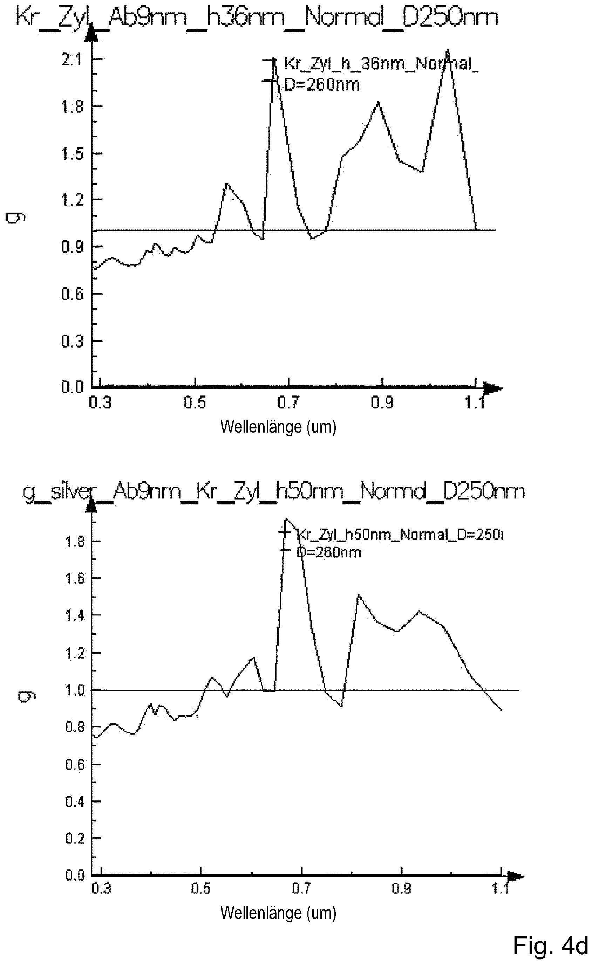

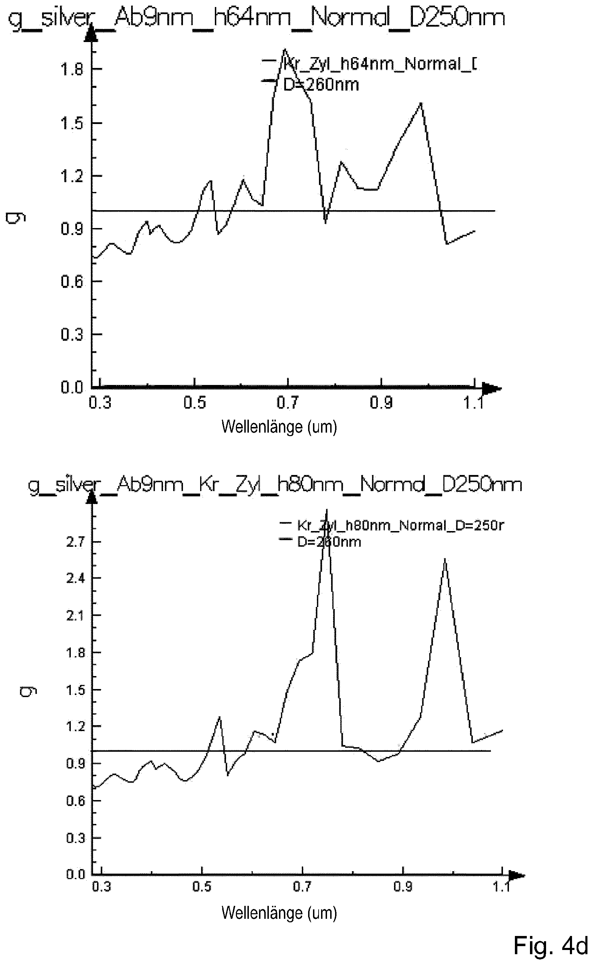

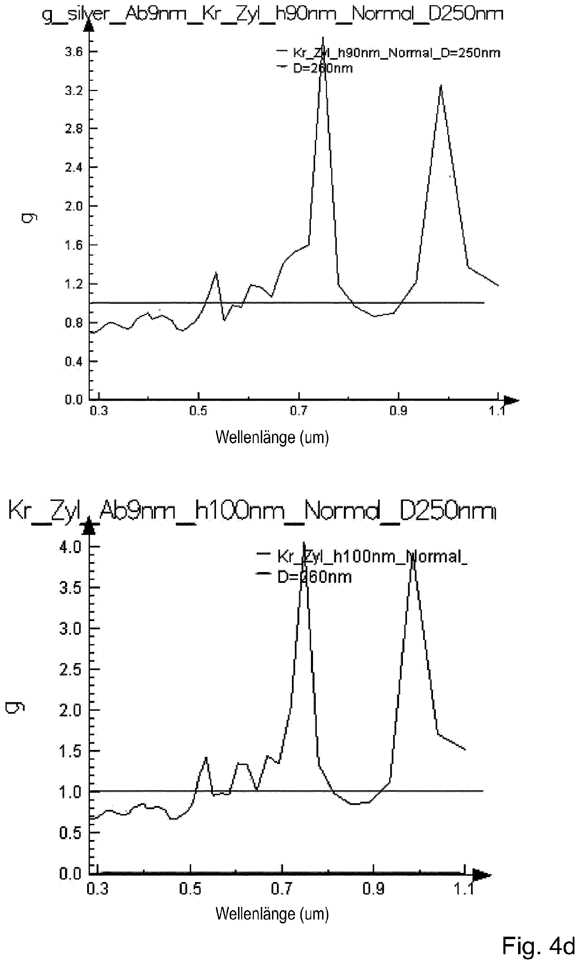

Fig. 4d zeigt Simulationsergebnisse zur Kreuzstruktur gemäß Serie 15. Es ist zu ersehen, dass zwei sehr starke Peaks bei etwa 1000 Nanometer und etwa 750 Nanometer vorliegen, mit einer bis zu 4-fachen Verstärkung. Der restliche Frequenzbereich bleibt unbeeinflusst bzw. wird nur relativ schwach verstärkt bis zu einem Bereich von ca. 550 Nanometer. Die Position der Peaks bzw. deren Höhe lässt sich durch die Designparameter beeinflussen.

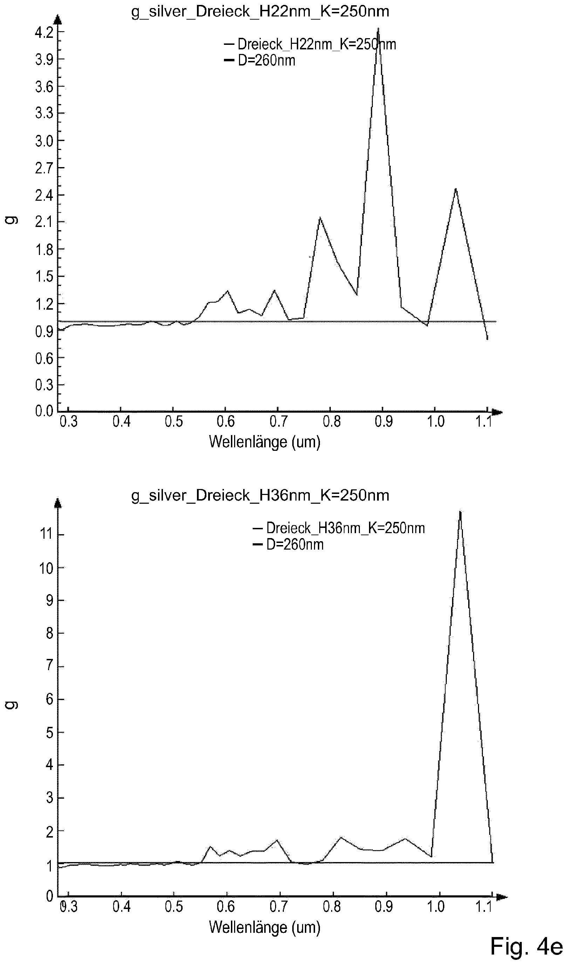

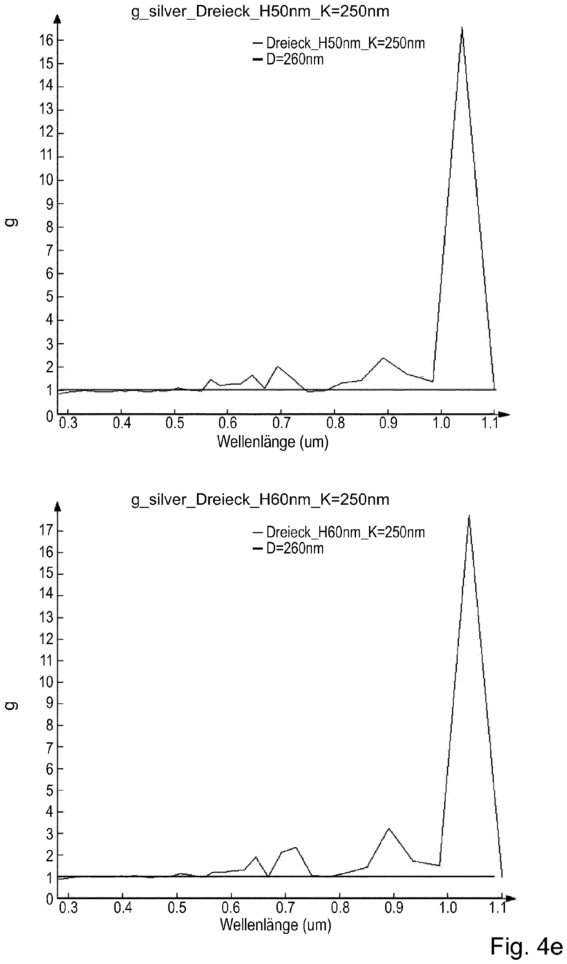

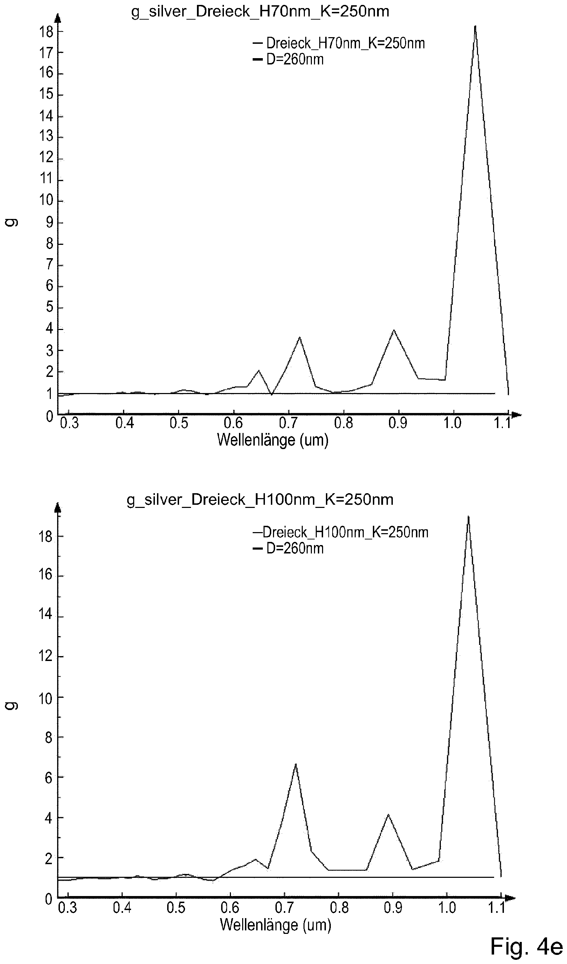

Fig. 4e zeigt Simulationsergebnisse zur Dreieckstruktur gemäß Serie 17. Es ist ersichtlich, dass ein sehr starker Peak bei etwa 1050 Nanometern mit einer bis zu 19-fachen Verstärkung auftritt. Der restliche Frequenzbereich bleibt unbeeinflusst bzw. wird nur relativ schwach verstärkt. Die Position der Peaks bzw. deren Höhe lassen sich durch die Designparameter beeinflussen.

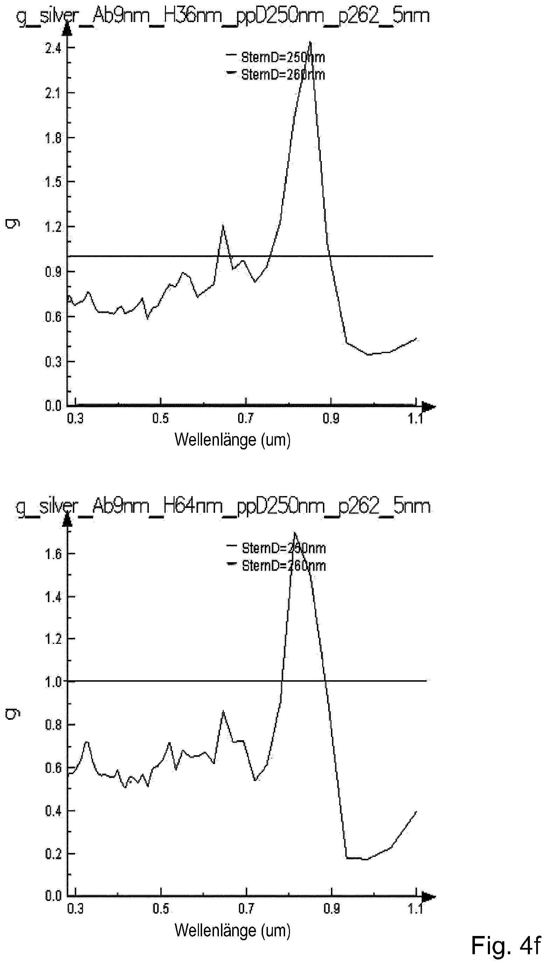

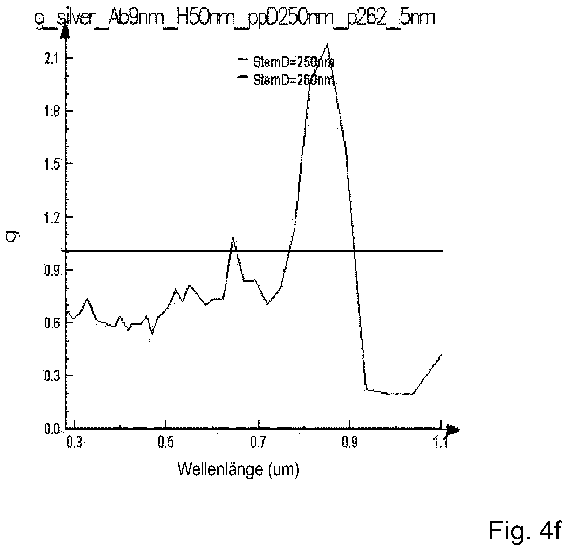

Fig. 4f zeigt Simulationsergebnisse zur Sternstruktur gemäß Serie 6 und 7. Man erkennt, dass ein sehr starker Peak bei etwa 825 Nanometer eine bis zu 3,3-fache Verstärkung bedeutet. Der restliche Frequenzbereich bleibt unbeeinflusst bzw. wird nur relativ schwach verstärkt. Die Position der Peaks bzw. deren Höhe lassen sich durch die Designparameter beeinflussen.

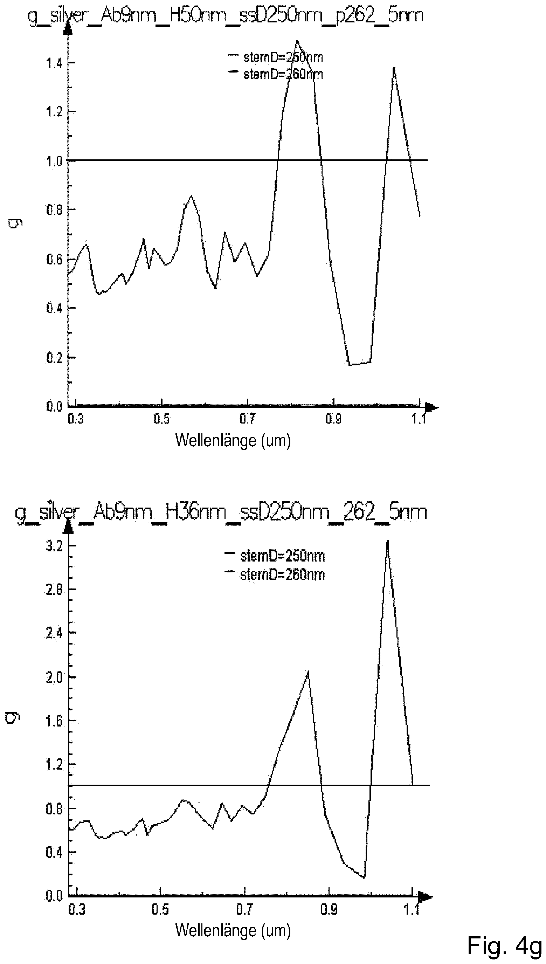

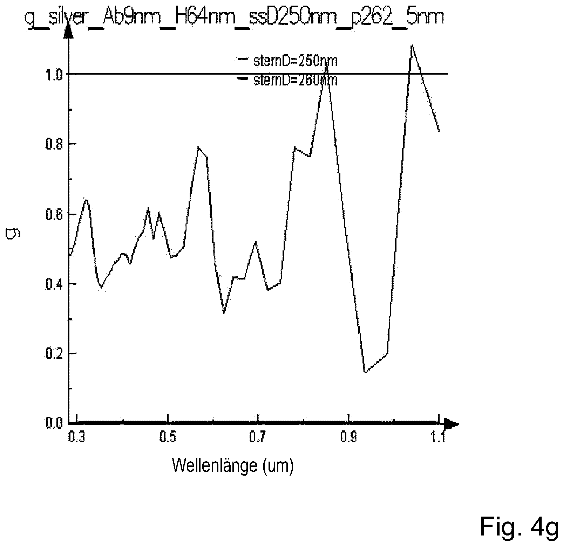

Fig. 4g bis l zeigt Simulationsergebnisse zur Quadratstruktur gemäß Serie 8. Es sind drei starke Peaks bei etwa 1100 Nanometer, 850 Nanometer und 725 Nanometer mit einer bis zu 7-fachen Verstärkung zu erkennen. Der restliche Frequenzbereich bleibt unbeeinflusst bzw. wird nur relativ schwach verstärkt. Die Position der Peaks bzw. deren Höhe lassen sich durch die Designparameter beeinflussen.

Aus den Simulationsergebnissen in den Fig. 4a bis 4l ist zusammenfassend ersichtlich, dass durch eine Variation der verschiedenen Disignparameter die Absorptionseigenschaften gezielt beeinflusst werden können, um bestimmte Frequenzbereiche zu verstärken, was für eine Anwendung als Sensor vorteilhaft ist.

Für eine Ultradünnschichtsolarzelle mit einer Absorberschicht mit einer Stärke von 150 Nanometern aus Silizium, einer Rückkontaktschicht aus Silber, einer Dicke von etwa 200 Nanometern, einer Antireflexionsschicht 16 mit einer Dicke von etwa 45 Nanometern aus Si3N4 und einer Schutzschicht aus Siliziumdioxid mit einer Dicke von etwa 64 Nanometern, wurden folgende Parameter als optimale Designparameter bestimmt:

Die Antennenelemente 22 sind zylindrisch in orthogonaler Anordnung mit einer Periode von 525 Nanometer. Der Radius beträgt 125 Nanometer und die Höhe h 70 Nanometer. Der Abstand d von der Absorberschicht 12 beträgt 9 Nanometer.

Als optimale Parameter für eine Standard-Dickschicht-Solarzelle mit einer Dicke von etwa 180 bis 200 Mikrometer wurden ermittelt:

Zylindrische Form der Antennenelemente in orthogonaler Anordnung mit einer Periode von 464,75 Nanometer. Der Radius der Zylinder beträgt 95 Nanometer und die Höhe h 70 Nanometer. Der Abstand d von der Absorberschicht 12 beträgt 9 Nanometer.

Bei Dickschicht-HIT-Zellen beträgt die Periode optimal 490 Nanometer.

## Patentansprüche

1. Photozelle, insbesondere Solarzelle, mit einer Absorberschicht (12), vor der eine Antireflexionsschicht (16) angeordnet ist, wobei die Antireflexionsschicht (16) eine nanostrukturierte Schicht (20) mit periodisch angeordneten Antennenelementen (22) aus einem elektrisch leitfähigen Material umfasst, die in einem Abstand (d) von 1 bis 50 Nanometer von der Absorberschicht (12) angeordnet ist und die zumindest teilweise in der Antireflexionsschicht (16) aufgenommen ist, wobei die Antennenelemente (22) eine Höhe von mehr als 30 bis 120 Nanometern haben, und wobei die nanostrukturierte Schicht (20) zusammen mit einem Rückkontakt (14) der Photozelle (10) einen optischen Resonator bildet, **dadurch gekennzeichnet, dass** die Antennenelemente in Abständen von mehr als 250 bis 750 Nanometern periodisch zueinander angeordnet sind.

2. Photozelle nach Anspruch 1 , **dadurch gekennzeichnet, dass** die nanostrukturierte Schicht (20) mit einem Abstand von 2 bis 20 Nanometer von der Absorberschicht (12) angeordnet ist, vorzugsweise mit einem Abstand von 5 bis 15 Nanometer, besonders bevorzugt mit einem Abstand von 7 bis 12 Nanometer.

3. Photozelle nach einem der vorhergehenden Ansprüche, **dadurch gekennzeichnet, dass** die Antennenelemente (22) eine maximale Ausdehnung in Querrichtung von 20 bis 400 Nanometern, vorzugsweise von 40 bis 250 Nanometern, besonders bevorzugt von 100 bis 250 Nanometern haben.

4. Photozelle nach einem der vorhergehenden Ansprüche, **dadurch gekennzeichnet, dass** die Antennenelemente (22) eine minimale Ausdehnung in Querrichtung von 25 Nanometern, vorzugsweise von 30 Nanometern, besonders bevorzugt von 50 Nanometern haben.

5. Photozelle nach einem der vorhergehenden Ansprüche, bei der die nanostrukturierte Schicht aus SiOₓN_{y}, Titanoxid oder ITO besteht.

6. Photozelle nach einem der vorhergehenden Ansprüche, **dadurch gekennzeichnet, dass** die nanostrukturierte Schicht (20) aus identischen Antennenelementen besteht oder aus Antennenelementen unterschiedlicher Form und/oder Größe, die in einem regelmäßigen Muster miteinander kombiniert sind.

7. Photozelle nach einem der vorhergehenden Ansprüche, **dadurch gekennzeichnet, dass** die nanostrukturierte Schicht aus kreisförmigen, vieleckförmigen, dreieckförmigen oder quadratischen Antennenelementen (22), aus kreuzförmigen Antennenelementen, in Form von miteinander gekreuzten Balken in symmetrischer Ausgestaltung, in Form eines Quadrats mit kleineren an jeder Außenseite angesetzten Quadraten in symmetrischer Ausgestaltung, in Form eines Quadrates mit quadratischen Aussparungen in jedem Eckbereich in symmetrischer Ausgestaltung, oder in Form eines Kreises mit vier tangential aufgesetzten Rechtecken in symmetrischer Ausgestaltung besteht, wobei die Rechtecke entweder in Richtung einer Elementarzelle angeordnet sind oder um 45° versetzt dazu, oder aus sternförmigen Elementen mit sechs Spitzen besteht, die hexagonal auf einer Elementarzelle angeordnet sind, wobei jeweils die Spitzen der sternförmigen Antennenelemente zueinander zeigen oder die Seiten zwischen den Spitzen zueinander zeigen.

8. Photozelle nach Anspruch 7, **dadurch gekennzeichnet, dass** die Antennenelemente (22) als Zylinder oder als gerade Prismen ausgebildet sind, die sich senkrecht zu einer Haupterstreckungsrichtung der Photozelle (10) erstrecken.

9. Photozelle nach einem der vorhergehenden Ansprüche, bei der die Antennenelemente aus einem Metall bestehen, das aus der Gruppe ausgewählt ist, die aus Silber, Kupfer, Aluminium, Gold und deren Legierungen besteht.

10. Photozelle nach einem der vorhergehenden Ansprüche, **dadurch gekennzeichnet, dass** die Antennenelemente aus einem Metall bestehen, das aus der Gruppe ausgewählt ist, die aus Silber, Kupfer, Aluminium, Gold und deren Legierungen besteht, und wobei zumindest eine dem Absorber zugewandte oder dem Absorber abgewandte Seite der Antennenelemente mit einem anderen Metall beschichtet ist, das aus der Gruppe ausgewählt ist, die aus Silber, Kupfer, Aluminium, Gold und deren Legierungen besteht.

11. Solarzelle nach einem der vorhergehenden Ansprüche, die als Siliziumsolarzelle ausgebildet ist, wobei die nanostrukturierte Schicht vorzugsweise aus geraden Zylindern besteht, **dadurch gekennzeichnet, dass** die nanostrukturierte Schicht aus Zylindern mit einem Durchmesser von 150 bis 250 Nanometern, vorzugsweise von 180 bis 200 Nanometern, und mit einer Höhe von 50 bis 90 Nanometern besteht, die vorzugsweise in einem orthogonalen Muster mit einem Abstand von 400 bis 600 Nanometern, vorzugsweise 450 bis 510 Nanometern angeordnet sind und einen Abstand zur Absorberschicht von 5 bis 13 Nanometern, vorzugsweise von 8 bis 10 Nanometern, aufweisen.

12. Solarzelle nach Anspruch 11, die als Standard-Dickschicht-Solarzelle mit einer Dicke von bis zu 200 Mikrometer ausgebildet ist, **dadurch gekennzeichnet, dass** die Zylinder der nanostrukturierten Schicht einen Durchmesser von 185 bis 195 Nanometern, vorzugsweise etwa 190 Nanometer, haben, eine Höhe von 68 bis 72 Nanometern, vorzugsweise etwa 70 Nanometer, einen Abstand zur Absorberschicht von 8,5 bis 9,5 Nanometern, vorzugsweise etwa 9 Nanometer, aufweisen und mit einem Abstand von 460 bis 470 Nanometern, vorzugsweise etwa 465 Nanometer, in einem orthogonalen Muster zueinander angeordnet sind.

13. Solarzelle nach Anspruch 12, die als HIT-Dickschicht-Solarzelle (10) mit einer Dicke von bis zu 200 Mikrometer ausgebildet ist, **dadurch gekennzeichnet, dass** die Zylinder der nanostrukturierten Schicht (20) einen Durchmesser von etwa 185 bis 195 Nanometern, vorzugsweise etwa 190 Nanometer, haben, eine Höhe (h) von 68 bis 72 Nanometern, vorzugsweise etwa 70 Nanometer, einen Abstand (d) zur Absorberschicht (12) von 8,5 bis 9,5 Nanometern, vorzugsweise etwa 9 Nanometer, aufweisen und mit einem Abstand von 485 bis 495 Nanometern, vorzugsweise etwa 490 Nanometer, in einem orthogonalen Muster zueinander angeordnet sind.

14. Solarzelle nach einem der Ansprüche 1 bis 10, die als Siliziumsolarzelle ausgebildet ist, insbesondere in Form einer Ultradünnschichtsolarzelle, **dadurch gekennzeichnet, dass** die nanostrukturierte Schicht aus Zylindern mit einem Durchmesser von 200 bis 300 Nanometern, vorzugsweise etwa 250 Nanometern, und mit einer Höhe (h) von 50 bis 90 Nanometern, vorzugsweise etwa 70 Nanometern, besteht, die in einem orthogonalen Muster mit einem Abstand von 400 bis 600 Nanometern, vorzugsweise etwa 525 Nanometern angeordnet sind und einen Abstand (d) zur Absorberschicht (12) von 5 bis 13 Nanometern, vorzugsweise von etwa 9 Nanometern, aufweisen.

## Claims

1. Photovoltaic cell, in particular a solar cell, comprising an absorber layer (12), in front of which an anti-reflection layer (16) is arranged, wherein the anti-reflection layer (16) comprises a nanostructured layer (20) with periodically arranged antenna elements (22) of an electrically conductive material, which is arranged at a distance (d) of 1 to 50 nanometers from the absorber layer (12), and which is at least partially received within the anti-reflection layer (16), wherein the antenna elements (22) have a height of more than 30 to 120 nanometers, and wherein the nanostructured layer (20) together with a back contact (14) of the photovoltaic cell (10) forms an optical resonator, **characterized in that** the antenna elements are arranged periodically with respect to each other at distances of 250 to 750 nanometers.

2. Photovoltaic cell according to claim 1, **characterized in that** the nanostructured layer (20) is arranged at a distance of 2 to 20 nanometers from the absorber layer (12), preferably at a distance of 5 to 15 nanometers, particularly preferred at a distance of 7 to 12 nanometers.

3. Photovoltaic cell according to any of the preceding claims, **characterized in that** the antenna elements (22) have a maximum extension in lateral direction of 20 to 400 nanometers, preferably of 40 to 250 nanometers, particularly preferred of 100 to 250 nanometers.

4. Photovoltaic cell according to any of the preceding claims, **characterized in that** the antenna elements (22) have a minimum extension in lateral direction of 25 nanometers, preferably of 30 nanometers, particularly preferred of 50 nanometers.

5. Photovoltaic cell according to any of the preceding claims, **characterized in that** the nanostructured layer consists of SiOₓN_{y}, titaniuim oxide or ITO.

6. Photovoltaic cell according to any of the preceding claims, **characterized in that** the nanostructured layer (20) consists of identical antenna elements or of antenna elements of different shapes and/or magnitudes which are combined with each other in a regular pattern.

7. Photovoltaic cell according to any of the preceding claims, **characterized in that** the nanostructured layer consists of circular, polygonal, triangular or quadratic antenna elements (22), of cross-shaped antenna elements in the form of bars crossed with each other in symmetrical configuration, in the shape of a square with smaller squares attached to each outer side in symmetrical configuration, in the shape of a square with quadratic recesses at each corner region in symmetrical configuration, or in the shape of a circle with four tangentially attached rectangles in symmetrical configuration, wherein the rectangles either extend In the direction of a unit cell or offset by 45° with respect thereto, or of star-shaped elements having six tips which are arranged hexagonally on a unit cell, wherein the tips each of the star-shaped antenna elements point towards each other, or the sides between the tips point towards each other.

8. Photovoltaic cell according to claim 7, **characterized in that** the antenna elements (22) are configured as cylinders or as straight prisms which extend perpendicularly to a main direction of extension of the photovoltaic cell (10).

9. Photovoltaic cell according to any of the preceding claims, wherein the antenna elements consist of a metal which is selected from the group consisting of silver, copper, aluminum, gold and alloys thereof.

10. Photovoltaic cell of any of the preceding claims, **characterized in that** the antenna elements consist of a metal which is selected from the group consisting of silver, copper, aluminum, gold and alloys thereof, and wherein at least one side of the antenna elements facing the absorber or facing away from the absorber is coated with a different material which is selected from the group consisting of silver, copper, aluminum, gold and alloys thereof.

11. Solar cell according to any of the preceding claims being configured as a solar cell, in particular as a silicon solar cell, wherein the nanostructured layer preferably consists of straight cylinders, **characterized in that** the nanostructured layer consists of cylinders with a diameter of 150 to 250 nanometers, preferably of 180 to 200 nanometers, and a height of 50 to 90 nanometers, which, preferably, are arranged in an orthogonal pattern at a distance of 400 to 600 nanometers, preferably of 450 to 510 nanometers, and at a distance to the absorber layer of 5 to 13 nanometers, preferably of 8 to 10 nanometers.

12. Solar cell according to claim 11, which is configured as a standard thick-layer solar cell with a thickness of up to 200 micrometers, **characterized in that** the cylinders of the nanostructured layer have a diameter of 185 to 195 nanometers, preferably about 190 nanometers, a height of 68 to 72 nanometers, preferably about 70 nanometers, a distance to the absorber layer of 8.5 to 9.5 nanometers, preferably about 9 nanometers, and at a distance of 460 to 470 nanometers, preferably about 465 nanometers, within an orthogonal pattern with respect to each other.

13. Solar cell according to claim 12, being configured as a HIT thick-layer solar cell (10) with a thickness if up to 200 micrometers, wherein the cylinders of the nanostructured layer (20) have a diameter of about 185 to 195 nanometers, preferably about 190 nanometers, a height (h) of 68 to 72 nanometers, preferably about 70 nanometers, a distance (d) to the absorber layer (12) of 8.5 to 9.5 nanometers, preferably about 9 nanometers, and are arranged in an orthogonal pattern with respect to each other at a distance of 485 to 495 nanometers, preferably about 490 nanometers.

14. Solar cell according to any of claims 1 to 10, being configured as silicon solar cell, in particular as an ultra-thin solar cell, **characterized in that** the nanostructured layer consists of cylinders with a diameter of 200 to 300 nanometers, preferably about 250 nanometers, and with a height (h) of 50 to 90 nanometers, preferably about 70 nanometers, which are arranged in an orthogonal pattern at a distance of 400 to 600 nanometers, preferably about 525 nanometers, and at a distance (d) to the absorber layer (12) of 5 to 13 nanometers, preferably of about 9 nanometers.

## Revendications

1. Cellule photoélectrique, en particulier cellule solaire, comportant une couche absorbante (12) devant laquelle est disposée une couche antiréfléchissante (16), dans laquelle la couche antiréfléchissante (16) comprend une couche nanostructurée (20) comportant des éléments d'antenne (22) en matériau électriquement conducteur selon un agencement périodique, qui est disposée à une distance (d) de 1 à 50 nanomètres de la couche absorbante (12) et qui est reçue au moins partiellement dans la couche antiréfléchissante (16), dans laquelle les éléments d'antenne (22) présentent une hauteur de plus de 30 à 120 nanomètres, et dans laquelle la couche nanostructurée (20) forme en association avec un contact arrière (14) de la cellule photoélectrique (10) un résonateur optique, **caractérisée en ce que** les éléments d'antenne sont disposés périodiquement à des distances supérieures à 250 à 750 nanomètres les uns des autres.

2. Cellule photoélectrique selon la revendication 1, **caractérisée en ce que** la couche nanostructurée (20) est disposée à une distance de 2 à 20 nanomètres de la couche absorbante (12), de préférence à une distance de 5 à 15 nanomètres, et de manière particulièrement préférable, de 7 à 12 nanomètres.

3. Cellule photoélectrique selon l'une quelconque des revendications précédentes, **caractérisée en ce que** les éléments d'antenne (22) présentent une extension transversale maximale de 20 à 400 nanomètres, de préférence de 40 à 250 nanomètres, et de manière particulièrement préférable, de 100 à 250 nanomètres.

4. Cellule photoélectrique selon l'une quelconque des revendications précédentes, **caractérisée en ce que** les éléments d'antenne (22) présentent une extension transversale minimale de 25 nanomètres, de préférence de 30 nanomètres, et de manière particulièrement préférable, de 50 nanomètres.

5. Cellule photoélectrique selon l'une quelconque des revendications précédentes, dans laquelle la couche nanostructurée est constituée de SiOₓN_{y}, d'oxyde de titane ou d'ITO.

6. Cellule photoélectrique selon l'une quelconque des revendications précédentes, **caractérisée en ce que** la couche nanostructurée (20) est constituée d'éléments d'antenne identiques ou d'éléments d'antenne de formes et/ou de tailles différentes qui sont combinés les uns aux autres selon un motif régulier.

7. Cellule photoélectrique selon l'une quelconque des revendications précédentes, **caractérisée en ce que** la couche nanostructurée est constituée d'éléments d'antenne circulaires, polygonaux, triangulaires ou carrés (22), d'éléments d'antenne cruciformes, sous forme de barres croisées agencées de manière symétrique, sous forme d'un carré comportant de plus petits carrés agencés de manière symétrique sur chaque côté extérieur, sous forme d'un carré comportant dans chaque zone d'angle des évidements carrés agencés de manière symétrique, ou sous forme d'un cercle comportant quatre rectangles tangentiels agencés de manière symétrique, dans laquelle les rectangles sont soit disposés dans la direction d'une cellule élémentaire, soit décalés de 45° par rapport à celle-ci, soit constitués d'éléments en forme d'étoile ayant six branches qui sont disposés de manière hexagonale sur une cellule élémentaire, dans laquelle les branches des éléments d'antenne en forme d'étoile sont orientés les unes vers les autres ou les côtés situés entre les branches sont orientés les uns vers les autres.

8. Cellule photoélectrique selon la revendication 7, **caractérisée en ce que** les éléments d'antenne (22) sont réalisés sous la forme de cylindres ou de prismes droits s'étendant perpendiculairement à une direction d'extension principale de la cellule photoélectrique (10).

9. Cellule photoélectrique selon l'une quelconque des revendications précédentes, dans laquelle les éléments d'antenne sont constitués d'un métal choisi dans le groupe constitué de l'argent, du cuivre, de l'aluminium, de l'or et d'alliages de ceux-ci.

10. Cellule photoélectrique selon l'une quelconque des revendications précédentes, **caractérisée en ce que** les éléments d'antenne sont constitués d'un métal choisi dans le groupe constitué de l'argent, du cuivre, de l'aluminium, de l'or et d'alliages de ceux-ci, et dans laquelle au moins un côté des éléments d'antenne qui est tourné vers l'absorbeur ou en sens opposé à l'absorbeur est revêtu d'un autre métal choisi dans le groupe constitué de l'argent, du cuivre, de l'aluminium, de l'or et d'alliages de ceux-ci.

11. Cellule solaire selon l'une quelconque des revendications précédentes, qui est réalisée sous la forme d'une cellule solaire au silicium, dans laquelle la couche nanostructurée est de préférence constituée de cylindres droits, **caractérisée en ce que** la couche nanostructurée comprend des cylindres présentant un diamètre de 150 à 250 nanomètres, de préférence de 180 à 200 nanomètres, et présentant une hauteur de 50 à 90 nanomètres, qui sont disposés de préférence de manière orthogonale à une distance de 400 à 600 nanomètres, de préférence de 450 à 510 nanomètres, et qui présentent une distance de 5 à 13 nanomètres, de préférence de 8 à 10 nanomètres, par rapport à la couche absorbante.

12. Cellule solaire selon la revendication 11, qui est une réalisée sous la forme d'une cellule solaire à couche épaisse standard présentant une épaisseur allant jusqu'à 200 micromètres, **caractérisée en ce que** les cylindres de la couche nanostructurée présentent un diamètre de 185 à 195 nanomètres, de préférence d'environ 190 nanomètres, présentent une hauteur de 68 à 72 nanomètres, de préférence d'environ 70 nanomètres, une distance par rapport à la couche absorbante de 8,5 à 9,5 nanomètres, de préférence d'environ 9 nanomètres, et sont disposés à une distance de 460 à 470 nanomètres, de préférence d'environ 465 nanomètres, selon un motif orthogonal les uns par rapport aux autres.

13. Cellule solaire selon la revendication 12, qui est réalisée sous la forme d'une cellule solaire à couche épaisse HIT (10) présentant une épaisseur allant jusqu'à 200 micromètres, **caractérisée en ce que** les cylindres de la couche nanostructurée (20) présentent un diamètre d'environ 185 à 195 nanomètres, de préférence d'environ 190 nanomètres, présentent une hauteur (h) de 68 à 72 nanomètres, de préférence d'environ 70 nanomètres, une distance (d) par rapport à la couche absorbante (12) de 8,5 à 9,5 nanomètres, de préférence d'environ 9 nanomètres, et sont disposés à une distance de 485 à 495 nanomètres, de préférence d'environ 490 nanomètres, selon un motif orthogonal les uns par rapport aux autres.

14. Cellule solaire selon l'une quelconque des revendications 1 à 10, qui est réalisée sous la forme d'une cellule solaire au silicium, en particulier sous la forme d'une cellule solaire à couches ultra-minces, **caractérisée en ce que** la couche nanostructurée est constituée de cylindres présentant un diamètre de 200 à 300 nanomètres, de préférence d'environ 250 nanomètres, et présentant une hauteur (h) de 50 à 90 nanomètres, de préférence d'environ 70 nanomètres, qui sont disposés selon un motif orthogonal avec un espacement de 400 à 600 nanomètres, de préférence d'environ 525 nanomètres, et présentent une distance (d) de 5 à 13 nanomètres, de préférence d'environ 9 nanomètres, par rapport à la couche absorbante (12).
